(19) Europäisches Patentamt
European Patent Office
Office européen des brevets

(11) **EP 2 715 384 B1**

(12) **EUROPÄISCHE PATENTSCHRIFT**

(45) Veröffentlichungstag und Bekanntmachung des Hinweises auf die Patenterteilung:
**15.07.2015 Patentblatt 2015/29**

(21) Anmeldenummer: **12728424.8**

(22) Anmeldetag: **24.05.2012**

(51) Int Cl.:
*G01R 33/07* (2006.01)     *G01R 33/00* (2006.01)

(86) Internationale Anmeldenummer:
**PCT/EP2012/059728**

(87) Internationale Veröffentlichungsnummer:
**WO 2012/160143 (29.11.2012 Gazette 2012/48)**

(54) **VERFAHREN ZUM BETREIBEN EINER HALLSENSORANORDNUNG UND HALLSENSORANORDNUNG**

METHOD FOR OPERATING A HALL SENSOR ASSEMBLY, AND HALL SENSOR ASSEMBLY

PROCÉDÉ DE FONCTIONNEMENT D'UN ENSEMBLE CAPTEUR À EFFET HALL ET ENSEMBLE CAPTEUR À EFFET HALL

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.05.2011 DE 102011102483**

(43) Veröffentlichungstag der Anmeldung:
**09.04.2014 Patentblatt 2014/15**

(73) Patentinhaber: **AMS AG**
**8141 Unterpremstätten (AT)**

(72) Erfinder:
• **RÖHRER, Georg**
  **A-8403 Lebring (AT)**
• **OBERHOFFNER, Gerhard**
  **A-8010 Graz (AT)**

(74) Vertreter: **Epping - Hermann - Fischer**
**Patentanwaltsgesellschaft mbH**
**Schloßschmidstraße 5**
**80639 München (DE)**

(56) Entgegenhaltungen:
DE-A1-102004 021 863     DE-A1-102007 044 471
US-A- 6 064 202

**Beschreibung**

Die vorliegende Erfindung betrifft ein Verfahren zum Betreiben einer Hallsensoranordnung und eine Hallsensoranordnung.

Hallsensoranordnungen dienen zum Bestimmen eines Magnetfeldes. Hallsensoren zeigen üblicherweise eine Offsetspannung, das heißt eine von Null verschiedene Ausgangsspannung zwischen zwei Kontakten des Hallsensors, sofern ein Strom zwischen zwei weiteren Kontakten des Hallsensors fließt, auch wenn sich der Hallsensor in keinem Magnetfeld befindet.

Dokument US 6,064,202 beschreibt ein Verfahren zur Reduzierung der Offsetspannung eines Hallsensors mittels Umschalten von Anschlüssen.

Im Dokument "Influence of the Junction Field Effect on the Offset Voltage of Integrated Hall Plates", P. Ruther et al., Sixteenth European Conference on Solid-State Transducers, 15. - 18. September 2002, Prag, Tschechische Republik, Seiten 1209 - 1212 wird die Abhängigkeit der Offsetspannung vom Eingangsstrom für verschiedene Hallbauelemente erläutert.

Dokument WO 00/54068 A1 befasst sich mit einem Verfahren zur Offset-kompensierten Magnetfeldmessung eines Hallsensors.

Dokument DE 102004021863 A1 beschreibt ein Sensorelement zum Bereitstellen eines Sensorsignals. Das Sensorelement umfasst ein Messelement mit vier Kontaktanschlüssen, eine Schalteinrichtung und eine Steuereinrichtung. Eine Steuergröße wird zwischen einem ersten und einem zweiten Kontaktanschluss in einer ersten Messphase mit einer ersten Polarität und in einer zweiten Messphase mit einer zur ersten Polarität entgegengesetzten Polarität angelegt.

Aufgabe der vorliegenden Erfindung ist es, ein Verfahren zum Betreiben einer Hallsensoranordnung und eine Hallsensoranordnung bereitzustellen, mit der ein Rest-Offsetwert im Betrieb ermittelt werden kann.

Die Aufgabe wird mit dem Verfahren gemäß Patentanspruch 1 und dem Gegenstand des Patentanspruchs 14 gelöst. Weiterbildungen und Ausgestaltungen sind jeweils Gegenstand der abhängigen Ansprüche.

In einer Ausführungsform umfasst ein Verfahren zum Betreiben einer Hallsensoranordnung das Einstellen mindestens zweier betragsmäßig unterschiedlicher Werte eines Eingangssignals eines Hallsensors der Hallsensoranordnung. Weiter werden die dazugehörenden Werte eines Ausgangssignals des Hallsensors bestimmt. Darüber hinaus wird ein Rest-Offsetwert des Ausgangssignals in Abhängigkeit von den Werten des Ausgangsignals ermittelt, die bei den mindestens zwei Werten des Eingangssignals bestimmt wurden.

Der Offsetanteil des Ausgangssignals und der magnetfeldabhängige Nutzanteil des Ausgangssignals hängen in unterschiedlicher Weise von der Höhe des Eingangssignals des Hallsensors ab. Daher kann vorteilhafterweise durch Beaufschlagen des Hallsensors mit zwei in der Höhe unterschiedlichen Werten des Eingangssignals der Rest-Offsetwert des Ausgangssignals bestimmt werden. Mit Vorteil ist eine Kalibrierung der Hallsensoranordnung mittels Bestimmen des Rest-Offsetwerts im Betrieb möglich. Vorteilhafterweise kann die Kalibrierung auch bei einem angelegten externen magnetischen Feld mit unbekannter Magnetfeldstärke durchgeführt werden.

In einer Ausführungsform wird das Ausgangssignal erst nach vollständigem Durchlaufen der Phasen eines Zyklusses der Current Spinning-Technik bereitgestellt. Dabei ist der Wert des Eingangssignals während der Phasen des Zyklusses der Current Spinning-Technik konstant. Die zu den mindestens zwei Werten des Eingangssignals dazugehörenden Werte des Ausgangssignals werden jeweils mittels eines eigenen Zyklusses der Current Spinning-Technik bereitgestellt. Die mindestens zwei Werte des Ausgangssignals werden somit bei den mindestens zwei Werten des Eingangssignals mittels mindestens zwei Zyklen der Current Spinning-Technik bestimmt. Die Current Spinning Technik kann als Strom-Dreh-Technik, Strom-Dreh-Verfahren oder Verfahren der rotierenden Betriebsströme bezeichnet werden. Mit Vorteil wird durch die Current Spinning-Technik der Offset in den Werten des Ausgangssignals bereits reduziert, ehe durch die Auswertung der mindestens zwei Werte des Ausgangssignals der Rest-Offsetwert ermittelt und von der Hallsensoranordnung ein Magnetfeldsignal generiert wird, das keinen Offset-Einfluss oder einen deutlich reduzierten Offset-Einfluss aufweist. Folglich gibt vorteilhafterweise das Magnetfeldsignal die Magnetfeldstärke mit hoher Genauigkeit an.

Das Eingangssignal kann als Strom oder Spannung realisiert sein.

In einer Ausführungsform wird der Rest-Offsetwert in Abhängigkeit von den mindestens zwei Werten des Eingangssignals und den Werten des Ausgangssignals, die bei den mindestens zwei Werten des Eingangssignals bestimmt wurden, berechnet.

Somit gehen nicht nur die Werte des Ausgangssignals, sondern auch die Werte des Eingangssignals in die Berechnung ein.

In einer alternativen Ausführungsform wird der Rest-Offsetwert in Abhängigkeit von den Werten des Ausgangssignals, die bei den mindestens zwei Werten des Eingangssignals bestimmt wurden, und von einem Skalierungsfaktor zwischen zwei Werten aus der Menge der mindestens zwei Werte des Eingangssignals berechnet. Es kann beispielsweise der Skalierungsfaktor und ein Wert aus der Menge der mindestens zwei Werte des Eingangssignals bei der Ermittlung des Rest-Offsetwerts verwendet werden.

Alternativ wird bei der Ermittlung des Rest-Offsetwerts der Skalierungsfaktor verwendet. In die Berechnung geht kein Wert des Eingangssignals ein.

In einer Ausführungsform sind die mindestens zwei Werte des Eingangssignals vorgegebene Werte. Auf Basis der vorgegebenen Werte des Eingangssignals kann mit Vorteil die Berechnung des Rest-Offsetwerts in der Hallsensoranordnung derart vereinfacht sein, dass die Werte des Eingangssignals mit anderen Parametern in Gleichungen zusammengefasst sind und nicht mehr explizit angegeben werden.

Der Rest-Offsetwert kann eine Rest-Offsetspannung oder ein Offsetfaktor sein.

In einer Ausführungsform ist eine Kalibrierphase zwischen einer ersten und einer zweiten Betriebsphase geschaltet. In der Kalibrierphase wird der Rest-Offsetwert ermittelt. Hingegen wird in der ersten und in der zweiten Betriebsphase der Wert des Magnetfelds in Abhängigkeit vom Rest-Offsetwert bestimmt.

In einer Ausführungsform wird die Hallsensoranordnung in einer ersten Kalibrierphase, anschließend in der ersten Betriebsphase, wiederum anschließend in einer zweiten Kalibrierphase und wiederum anschließend in der zweiten Betriebsphase betrieben. Da mit Vorteil die Hallsensoranordnung im Betrieb kalibrierbar ist, können sich Kalibrier- und Betriebsphasen mehrfach abwechseln. Somit kann der Einfluss von Änderungen des Offsetwerts, die durch Alterung, Temperaturänderungen oder mechanischen Stress etwa bei Lötprozessen erzeugt werden, verringert werden.

In einer Ausführungsform wird die Kalibrierphase dann getriggert, wenn ein Triggersignal der Hallsensoranordnung zugeleitet wird.

In einer alternativen Ausführungsform wird ein Taktsignal generiert, das eine Kalibrierphase in vorgegebenen Zeitabständen startet. Das Taktsignal hat insbesondere eine konstante Frequenz.

In einer alternativen Ausführungsform wird die Kalibrierphase dann getriggert, wenn eine Temperaturänderung der Hallsensoranordnung größer als ein vorgegebener Grenzwert ist. Dazu weist die Hallsensoranordnung einen Temperatursensor auf, welcher ein Temperatursignal bereitstellt, mit dem die Temperaturänderung bestimmt wird.

Die Hallsensoranordnung kann in einem System integriert sein. Ein derartiges System kann etwa ein Kraftfahrzeug, eine Werkzeugmaschine, ein Strommessgerät, ein Kompass oder ein Roboter sein.

In einer Ausführungsform wird die Kalibrierphase getriggert, während sich das System in einem Ruhezustand befindet. Mit Vorteil sind in einem Ruhezustand des Systems die Störungen gering gehalten, so dass eine besonders hohe Genauigkeit bei der Bestimmung des Rest-Offsetwerts erzielt wird.

In einer Ausführungsform ist der Rest-Offsetwert eine Rest-Offsetspannung. Die Rest-Offsetspannung kann gemäß folgender Gleichung berechnet werden:

$$\mathrm{VOFF} = \mathrm{k} \cdot \mathrm{I}^{\mathrm{n}},$$

wobei VOFF der Wert der Rest-Offsetspannung, k der Wert eines Offsetfaktors, I der Wert des Eingangssignals und n der Wert eines Exponenten ist.

In einer Ausführungsform ist der Rest-Offsetwert ein Offsetfaktor. Der Offsetfaktor kann gemäß folgender Gleichung berechnet werden:

$$\mathrm{k} = \frac{\mathrm{VOFF}}{\mathrm{I}^{\mathrm{n}}},$$

wobei VOFF der Wert der Rest-Offsetspannung, k der Wert des Offsetfaktors, I der Wert des Eingangssignals und n der Wert des Exponenten ist.

In einer Ausführungsform wird der Wert des Magnetfelds gemäß folgender Gleichung ermittelt:

$$\mathrm{V} = \mathrm{B} \cdot \mathrm{S} \cdot \mathrm{I} + \mathrm{VOFF},$$

wobei V der Wert des Ausgangssignals, B der Wert des Magnetfelds, S der Wert einer Empfindlichkeit, I der Wert des Eingangssignals und VOFF der Wert der Rest-Offsetspannung ist.

In einer Ausführungsform ist der Wert der Empfindlichkeit vorgegeben.

In einer alternativen Ausführungsform ist eine Spule derart zum Hallsensor angeordnet, dass das Magnetfeld der Spule das vom Hallsensor detektierte Magnetfeld beeinflusst, und wird der Wert der Empfindlichkeit bei den mindestens zwei Werten des Eingangssignals mittels der Spule ermittelt.

In einer Ausführungsform ist die Hallsensoranordnung zur Durchführung des Verfahrens zum Betreiben der Hallsensoranordnung geeignet oder ausgelegt.

In einer Ausführungsform umfasst eine Hallsensoranordnung einen Hallsensor, eine Signalquelle und eine Ermittlungseinheit. Die Signalquelle ist mit einem Eingang des Hallsensors gekoppelt. Die Ermittlungseinheit ist mit einem Ausgang des Hallsensors gekoppelt. Die Signalquelle ist eingerichtet, mindestens zwei betragsmäßig unterschiedliche Werte eines Eingangssignals des Hallsensors bereitzustellen. Weiter ist die Ermittlungseinheit eingerichtet, einen Rest-Offsetwert eines Ausgangssignals des Hallsensors in Abhängigkeit von den Werten des Ausgangssignals, die bei den mindestens zwei Werten des Eingangssignals bestimmt werden, zu ermitteln.

Mit Vorteil ist mittels zweier unterschiedlicher Werte des Eingangssignals der Rest-Offsetwert bestimmbar.

In einer Ausführungsform umfasst der Hallsensor ein Hallelement und eine Eingangsschaltung, die einen Eingang des Hallsensors mit dem Hallelement verbindet. Weiter umfasst der Hallsensor eine Ausgangsschaltung und eine Auswerteschaltung, die das Hallelement mit einem Ausgang des Hallsensors verbinden. Die Ausgangsschaltung und die Auswerteschaltung sind seriell zueinander geschaltet. Ein von der Auswerteschaltung bereitgestelltes Ausgangssignal wird erst nach vollständigem Durchlaufen der Phasen eines Zyklusses der Current Spinning-Technik bereitgestellt.

Die Eingangsschaltung, die Ausgangsschaltung und die Auswerteschaltung dienen der Durchführung der Current Spinning-Technik.

In einer Weiterbildung beträgt mindestens ein Wert des Eingangssignals mindestens das 1,5-fache des kleinsten Werts des Eingangssignals. Zwischen zwei Werten des Eingangssignals ist somit mindestens ein Unterschied von 50 %, so dass sich die Werte des Eingangssignals und damit die Werte des Ausgangssignals deutlich unterscheiden. Dies erleichtert eine numerische stabile Berechnung des Rest-Offsetwerts.

Die Hallsensoranordnung kann einen Halbleiterkörper umfassen. Der Halbleiterkörper kann ein Siliziumsubstrat aufweisen. Bevorzugt sind der Hallsensor, die Signalquelle und die Ermittlungseinheit auf einer ersten Hauptfläche des Halbleiterkörpers angeordnet.

In einer Ausführungsform umfasst die Hallsensoranordnung eine Spule. Die Spule kann auf der ersten Hauptfläche des Halbleiterkörpers angeordnet sein. Die Spule kann derart zum Hallsensor angeordnet sein, dass die Spule ein Magnetfeld erzeugt, das vom Hallsensor detektiert wird. Dabei detektiert der Hallsensor die Summe aus dem externen Magnetfeld und dem von der Spule erzeugten Magnetfeld.

Die Erfindung wird im Folgenden an mehreren Ausführungsbeispielen anhand der Figuren näher erläutert. Funktions- beziehungsweise wirkungsgleiche Komponenten oder Funktionseinheiten tragen gleiche Bezugszeichen. Insoweit sich Komponenten oder Funktionseinheiten in ihrer Funktion entsprechen, wird deren Beschreibung nicht in jeder der folgenden Figuren wiederholt. Es zeigen:

Figuren 1A bis 1D    eine beispielhafte Ausführungsform einer Hallsensoranordnung, die zur Durchführung einer ersten und einer zweiten Ausführungsform des Verfahrens zum Betreiben einer Hallsensoranordnung geeignet ist, und beispielhafte Messergebnisse,

Figuren 2A bis 2D    weitere beispielhafte Ausführungsformen der Hallsensoranordnung, die zur Durchführung einer dritten und einer vierten Ausführungsform des Verfahrens zum Betreiben der Hallsensoranordnung eingerichtet sind, und dazugehörende Messergebnisse,

Figuren 3A bis 3E    weitere beispielhafte Ausführungsformen der Hallsensoranordnung, die zur Durchführung eines fünften und eines sechsten Verfahrens zum Betreiben der Hallsensoranordnung eingerichtet sind, und dazugehörige Messergebnisse sowie

Figuren 4A und 4B    beispielhafte Ausführungsformen von Details der Hallsensoranordnung.

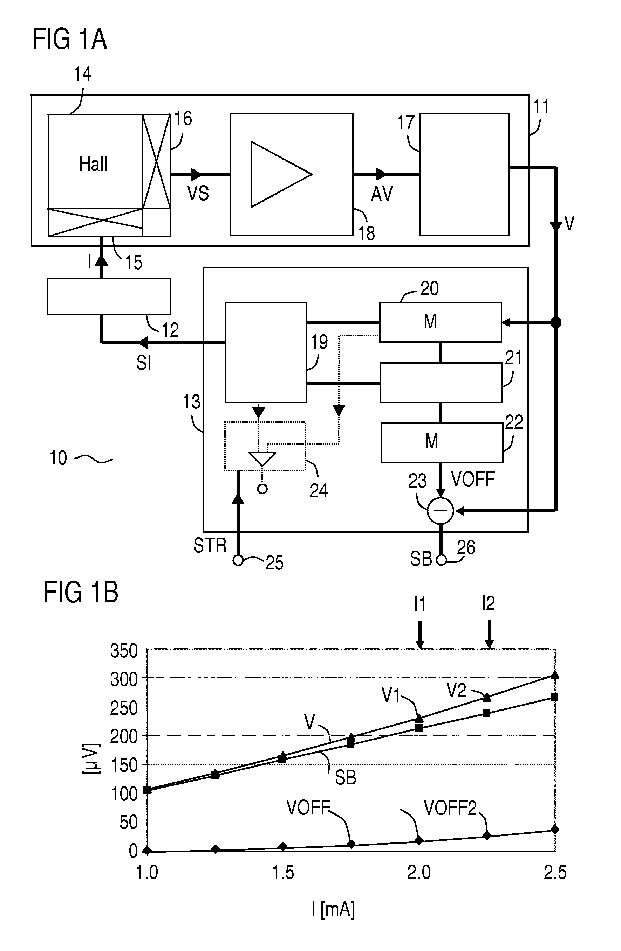

Figur 1A zeigt eine beispielhafte Ausführungsform einer Hallsensoranordnung. Die Hallsensoranordnung 10 umfasst einen Hallsensor 11, eine Signalquelle 12 und eine Ermittlungseinheit 13. Die Signalquelle 12 ist an einem Ausgang mit einem Eingang des Hallsensors 11 verbunden. Ein Ausgang des Hallsensors 11 ist mit einem Signaleingang der Ermittlungseinheit 13 gekoppelt. Ein Steuerausgang der Ermittlungseinheit 13 wiederum ist mit einem Eingang der Signalquelle 12 verbunden. Darüber hinaus umfasst der Hallsensor 11 ein Hallelement 14, eine Eingangsschaltung 15 und eine Ausgangsschaltung 16. Die Eingangsschaltung 15 verbindet den Eingang des Hallsensors 11 mit dem Hallelement 14. Das Hallelement 14 ist über die Ausgangsschaltung 16 mit dem Ausgang des Hallsensors 11 verbunden. Eine Auswerteschaltung 17 ist zwischen dem Ausgang der Ausgangsschaltung 16 und dem Ausgang des Hallsensors 11 angeordnet. Zwischen dem Ausgang der Ausgangsschaltung 16 und der Auswerteschaltung 17 ist ein Verstärker 18 angeordnet.

Die Ermittlungseinheit 13 weist eine Steuerschaltung 19, einen Speicher 20 und eine Berechnungseinheit 21 auf. Der Speicher 20 ist mit dem Signaleingang der Ermittlungseinheit 13 verbunden. Weiter ist der Speicher 20 mit der Berechnungseinheit 21 sowie der Steuerschaltung 19 gekoppelt. Ebenso ist die Berechnungseinheit 21 mit der Steuerschaltung 19 verbunden. Die Steuerschaltung 19 ist mit dem Steuerausgang der Ermittlungseinheit 13 verbunden. Zusätzlich weist die Ermittlungseinheit 13 einen weiteren Speicher 22 und einen Subtrahierer 23 auf. Ein Eingang des Subtrahierers 23 ist mit dem Signaleingang der Ermittlungseinheit 13 verbunden. Ein weiterer Eingang des Subtrahierers 23 ist über den weiteren Speicher 22 mit einem Ausgang der Berechnungseinheit 21 gekoppelt. Ferner umfasst die Ermittlungseinheit 13 einen Vergleicher 24, der eingangsseitig mit dem Speicher 20 sowie der Steuerschaltung 19 verbunden ist. Die Ermittlungseinheit 13 weist einen Triggereingang 25 auf. Die Ermittlungseinheit 13 ist als Digital-Signalprozessor realisiert. Alternativ ist die Ermittlungseinheit 13 als Mikrocontroller oder Mikroprozessor implementiert.

Die Signalquelle 12 gibt ein Eingangssignal I an den Hallsensor 11 ab. Das Eingangssignal I ist als Strom realisiert.

Die Signalquelle 12 ist als Bias-Schaltkreis ausgebildet. Der Hallsensor 11 stellt ein Ausgangssignal V an seinem Ausgang bereit. Das Ausgangssignal V liegt in der Form einer Spannung vor. Die Eingangsschaltung 15, das Hallelement 14 und die Ausgangsschaltung 16 wandeln das Eingangssignal I in ein Sensorsignal VS um. Die Eingangsschaltung 15, das Hallelement 14 und die Ausgangsschaltung 16 bilden zusammen ein gechopptes Sensorelement. Das Sensorsignal VS wird vom Verstärker 18 in ein verstärktes Sensorsignal AV umgewandelt. Die Auswerteschaltung 17 generiert aus dem verstärkten Sensorsignal AV das Ausgangssignal V des Hallsensors 11. Die Auswerteschaltung 17 ist als De-Chop Schaltung realisiert. Die Auswerteschaltung 17 kann einen Schalter, einen Inverter, einen Komparator oder einen Analog-Digital-Wandler umfassen. Das Ausgangssignal V wird dem Signaleingang der Ermittlungseinheit 13 zugeleitet. Somit wird das Ausgangssignal V dem Speicher 20 und dem Subtrahierer 23 zugeführt. Der Subtrahierer 23 gibt ausgangseitig ein Magnetfeldsignal SB ab. Der Subtrahierer 23 ist als Digitalsubtrahierer realisiert. Ein Triggersignal STR am Triggereingang 25 löst eine Kalibrierung gemäß einem der nachstehend beschriebenen Verfahren aus.

Die Eingangsschaltung 15 und die Ausgangsschaltung 16 weisen Schalter auf. Damit werden entsprechend der Current Spinning-Technik die Anschlüsse des Hallelements 14 periodisch umgeschaltet. Das Sensorsignal VS und das verstärkte Sensorsignal AV hängen somit von der Stellung der Schalter in der Eingangs- und der Ausgangsschaltung 15, 16 ab. Die Auswerteschaltung 17 ist ausgelegt, aus dem Sensorsignal VS beziehungsweise dem verstärkten Sensorsignal AV das Ausgangssignal V zu generieren. Das Ausgangssignal V wird somit nach Durchführung der Current Spinning-Technik bereitgestellt. Das Ausgangssignal V wird von der Auswerteschaltung 17 aus den während einer Periode eines Zyklus der Current Spinning-Technik generierten Werten des Sensorsignals VS beziehungsweise des verstärkten Sensorsignals AV erzeugt. Das Ausgangssignal V weist somit nur mehr einen geringen Offset-Signalanteil auf, der auch als Rest-Offsetsignalanteil bezeichnet wird. Die Ermittlungseinheit 13 ist derart implementiert, dass sie einen Rest-Offsetwert in Form einer Rest-Offsetspannung VOFF bestimmt und im weiteren Speicher 22 abspeichert. Der Subtrahierer 23 zieht somit vom Ausgangssignal V die Rest-Offsetspannung VOFF ab, so dass das Magnetfeldsignal SB einen deutlich verringerten verbleibenden Rest-Offsetanteil aufweist. Das vom Subtrahierer 23 abgegebene Magnetfeldsignal SB ist somit näherungsweise offsetfrei. Der Subtrahierer 23 zieht zur Ermittlung des Magnetfeldsignals SB von allen folgenden Werten des Ausgangssignals V den Wert der Rest-Offsetspannung VOFF gemäß folgender Gleichung ab:

$$SB = V - VOFF$$

Das Magnetfeldsignal SB ist direkt proportional zum Magnetfeld B. Die Stromabhängigkeit der Rest-Offsetspannung VOFF wird gemäß folgender Gleichung berechnet:

$$VOFF = k \cdot I^{n},$$

wobei VOFF der Wert der Rest-Offsetspannung, k der Wert eines Offsetfaktors, I der Wert des Eingangssignals und n der Wert eines Exponenten ist. Der Offsetfaktor k ist eine einheitenbehaftete Zahl. Der Offsetfaktor k hat die Einheit Volt / Ampere$^{n}$.

In einer alternativen, nicht gezeigten Ausführungsform weist der Hallsensor 11 einen Analog-Digital-Wandler auf, der zwischen der Auswerteschaltung 17 und dem Ausgang des Hallsensors 11 angeordnet ist. Das Ausgangssignal V liegt somit als Digitalsignal vor.

In einer alternativen Ausführungsform ist das Ausgangssignal V als Strom ausgebildet.

In einer alternativen Ausführungsform ist das Eingangssignal I als Spannung realisiert. Das Ausgangssignal V kann eine Spannung oder ein Strom sein.

Somit sind vier verschiedene Betriebsarten des Hallsensors möglich. 1. Strom als Eingangssignal I - Spannung als Ausgangssignal V. 2. Spannung als Eingangssignal I - Spannung als Ausgangssignal V. 3. Strom als Eingangssignal I und Strom als Ausgangssignal V und 4. Spannung als Eingangssignal I und Strom als Ausgangssignal V. Auch wenn bei den oben und weiter unten angegebenen Formeln von einem Strom als Eingangssignal I und einer Spannung als Ausgangssignal V ausgegangen wird, sind die angegebenen Verfahren unter Verwendung angepasster Gleichungen auch für die drei weiteren Betriebsarten des Hallsensors 11 verwendbar.

In einer alternativen Ausführungsform umfasst die Hallsensoranordnung 10 weitere Hallelemente. Die weiteren Hallelemente können zusammen mit dem Hallelement 14 ein Hallsensorarray bilden. Die verschiedenen Hallelemente können parallel und/oder seriell zueinander geschaltet sein. Die Ermittlungseinheit 13 kann dazu ausgelegt sein, aus dem Signal mehrerer Hallsensoren eine Winkelinformation zu ermitteln. Die Ermittlungseinheit 13 kann dazu ausgelegt sein, gemäß dem Verfahren des coordinate rotation digital computers, abgekürzt CORDIC-Verfahren, aus dem Signal mehrerer Hallsensoren die Winkelinformation zu ermitteln. Die Ermittlungseinheit 13 kann alternative Algorithmen wie etwa die Berechnung mittels einer Tabelle, englisch lookup table, zur Ermittlung der Winkelinformation aus dem Signal mehrerer Hallsensoren verwenden.

Figur 1B zeigt eine beispielhafte Messung an einem Hallsensor 11. In Abhängigkeit von dem Eingangssignal I sind das Ausgangssignal V, die Rest-Offsetspannung VOFF und das Magnetfeldsignal SB angegeben.

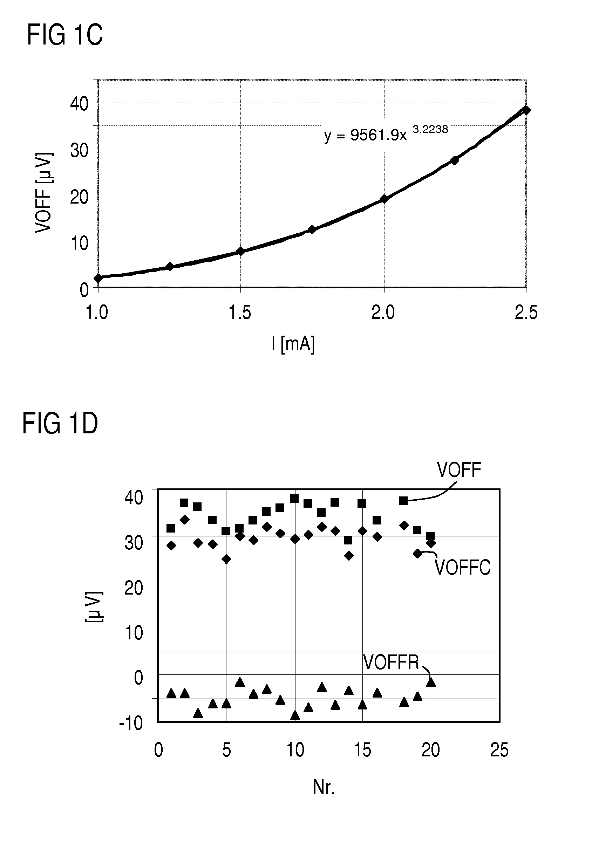

Figur 1C zeigt die in Figur 1B angegebenen Werte der Rest-Offsetspannung VOFF in vergrößerter Darstellung. Dabei ist die Rest-Offsetspannung VOFF über dem Eingangssignal I aufgetragen. Die durchgezogene Linie wurde gemäß dem Prinzip der kleinsten Fehlerquadrate aus den Messwerten berechnet. Dabei ist der Rest-Offsetwert VOFF proportional zu $I^{3.2238}$.

Laut Publikation "Influence of the Junction Field Effect on the Office Voltage of Integrated Hall Plate", P. Ruther et al., Sixteenth European Conference on Solid-State Transducers, 15. - 18. September 2002, Prag, Tschechische Republik, Seiten 1209 - 1212 weist die Rest-Offsetspannung VOFF eine quadratische Abhängigkeit vom Eingangssignal I auf, sofern der Zyklus der Current Spinning-Technik zwei Phasen aufweist. Weiter ist die Rest-Offsetspannung VOFF proportional zu $I^3$ für eine Current Spinning-Technik, deren Zyklus vier Phasen aufweist.

Die nichtlineare Abhängigkeit der Rest-Offsetspannung VOFF vom Eingangssignal I wird verwendet, um die Rest-Offsetspannung VOFF aus mindestens zwei Messungen, die bei zwei verschiedenen Werten des Eingangssignals I vorgenommen werden, zu extrahieren. Das Ausgangssignal V des Hallsensors 11 kann gemäß folgender Gleichung beim einem ersten Wert I1 und einem zweiten Wert 12 des Eingangssignals I berechnet werden:

$$V1 = B \cdot S(I1) \cdot I1 + VOFF1,$$

$$VOFF1 = k \cdot I1^n,$$

$$V2 = B \cdot S(I2) \cdot I2 + VOFF2,$$

$$VOFF2 = k \cdot I2^n,$$

wobei V1 und V2 ein erster beziehungsweise ein zweiter Wert des Ausgangssignals, B der Wert eines Magnetfeld, S(I1) und S(I2) der erste beziehungsweise der zweite Wert einer Empfindlichkeit, I1 und 12 der erste beziehungsweise der zweite Wert des Eingangssignals und VOFF1 sowie VOFF2 der erste beziehungsweise der zweite Wert der Rest-Offsetspannung sind. Der Absolutwert des ersten Werts I1 des Eingangssignals I und der Absolutwert des zweiten Werts 12 des Eingangssignals I sind verschieden. Der Absolutwert des ersten Werts I1 des Eingangssignals I ist kleiner als der Absolutwert des zweiten Werts 12 des Eingangssignals I. Der Wert der Empfindlichkeit S hängt vom Wert des Eingangssignals I ab und wird daher als Funktion S(I) mit dem Parameter I in Klammern angegeben. Der Wert des Offsetfaktors k kann gemäß folgender Gleichung aus den obigen Gleichungen bestimmt werden:

$$k = \frac{V2 - V1 \cdot \dfrac{I2 \cdot S(I2)}{I1 \cdot S(I1)}}{I2^n - I1^{n-1} \cdot \dfrac{S(I2)}{S(I1)}},$$

Bei einem vorgegebenen Wert Iv des Eingangssignals I lässt sich somit der dazugehörige Wert der Rest-Offsetspannung VOFFv und der Wert des Magnetfelds B berechnen. Der vorgegebene Wert Iv des Eingangssignals I kann gleich dem ersten Wert I1 oder dem zweiten Wert 12 oder ein zwischen dem ersten Wert I1 und dem zweiten Wert 12 liegender Wert des Eingangssignals I sein. Somit gilt:

$$Vv = B \cdot S(Iv) \cdot Iv + VOFFv,$$

$$VOFFv = k \cdot Iv^n,$$

$$I1 \leq Iv \leq I2$$

$$SB = Vv - VOFFv = B \cdot S(Iv) \cdot Iv$$

Alternativ kann der vorgegebene Wert Iv des Eingangssignals I außerhalb des vom ersten Wert I1 und vom zweiten Wert 12 begrenzten Bereichs sein.

Beim niedrigeren Wert von den beiden Werten I1, 12 des Eingangssignals I wird eine längere Messdauer als beim höheren Wert von den beiden Werten I1, 12 des Eingangssignals I eingestellt. Die Messdauer kann die Periode eines Zyklusses der Current Spinning-Technik sein. Damit kann die Messdauer die Summe der Dauer der Phasen der Current Spinning-Technik sein. Gilt beispielsweise I1 = 2 * 12, so kann die gesamte Messdauer neun Minuten, die Messdauer beim ersten Wert I1 eine Minute und die Messdauer beim zweiten Wert 12 acht Minuten betragen. Ist die gesamte Messdauer 360 $\mu$s, so kann die Messdauer beim ersten Wert I1 40 $\mu$s und die Messdauer beim zweiten Wert 12 320 $\mu$s sein. Das Verhältnis der Messdauer beim ersten Wert 12 zur Messdauer beim zweiten Wert I1 kann größer als das Verhältnis I1/I2 sein, sofern I1>I2 gilt. Das Verhältnis der Messdauer beim ersten Wert 12 zur Messdauer beim zweiten Wert I1 kann kleiner als das Verhältnis I1/I2 sein, sofern I1<I2 gilt. Somit wird der Einfluss des Rauschens reduziert.

In einer ersten Ausführungsform des Verfahrens wird die Stromabhängigkeit der Empfindlichkeit S vernachlässigt. Weiter wird ein vorgegebener Wert für den Exponent n verwendet. Somit können die obigen Gleichungen vereinfacht und der Offsetfaktor k, die Werte der Rest-Offsetspannung VOFF, das Magnetfeldsignal SB und das Produkt aus dem Wert des Magnetfelds B und dem Wert der Empfindlichkeit S gemäß folgenden Gleichungen berechnet werden:

$$k = \frac{V2 - V1 \cdot \frac{I2}{I1}}{I2^n - I1^{n-1} \cdot I2},$$

$$VOFF1 = k \cdot I1^n,$$

$$VOFF2 = k \cdot I2^n,$$

$$VOFFv = k \cdot Iv^n,$$

$$B \cdot S = \frac{V1 - VOFF1}{I1} = \frac{V2 - VOFF2}{I2} = \frac{Vv - VOFFv}{Iv},$$

$$SB = V1 - VOFF1 = V2 - VOFF2 = Vv - VOFFv$$

Mindestens einer der Werte I1, 12, Iv des Eingangsignals I, der Offsetspannung VOFF und/oder der Offsetfaktor k werden im weiteren Speicher 22 gespeichert.

In einer zweiten Ausführungsform des Verfahrens werden nicht nur der Offsetfaktor k, sondern ebenfalls der Wert des Exponenten n ermittelt. Dazu werden wie oben angegeben der erste und der zweite Wert V1, V2 des Ausgangssignals V beim ersten und beim zweiten Wert I1, I2 des Eingangssignals I und zusätzlich ein dritter Wert V3 des Ausgangssignals V bei einem dritten Wert I3 des Eingangssignals I gemessen. Der erste, der zweite und der dritte Wert I1, I2, I3 des Eingangssignals I weisen unterschiedliche Beträge auf. Die Bestimmung der Größen k, n und VOFF geschieht mittels eines iterativen Berechnungsverfahren. Der dritte Wert V3 des Ausgangssignals V folgt folgender Gleichung:

$$V3 = B \cdot S \cdot I3 + VOFF3,$$

$$VOFF3 = k \cdot I3^{n},$$

$$I1 < I2 < I3$$

Aus den obigen Gleichungen für den ersten, zweiten und dritten Wert V1, V2, V3 des Ausgangssignals V ergeben sich folgende Gleichungen:

$$a \cdot I1^{n} + b \cdot I2^{n} + c \cdot I3^{n+1} = 0,$$

$$a = S \cdot I3 \cdot (V2 \cdot S \cdot I3 - V3 \cdot S \cdot I2),$$

$$b = S \cdot I3 \cdot (V3 \cdot S \cdot I1 - V1 \cdot S \cdot I3),$$

$$c = S \cdot (V1 \cdot S \cdot I2 - V2 \cdot S \cdot I1)$$

Diese Gleichungen werden numerisch von der Ermittlungseinheit 13 gelöst und so der Wert des Exponenten n und anschließend der Wert des Offset-Faktors k ermittelt.

Die Steuerschaltung 19 stellt mittels des Steuersignals SI die Signalquelle 12 so ein, dass der erste Wert I1 des Eingangssignals I dem Hallsensor 11 bereitgestellt wird. Der erste Wert V1 des Ausgangssignals V des Hallsensors 11 wird dann in der Ermittlungseinheit 13 im Speicher 20 abgespeichert. Weiter stellt die Steuerschaltung 19 mittels des Steuersignals SI den zweiten Wert I2 des Eingangssignals I bereit und wird der zweite Wert V2 des Ausgangssignals V in der Ermittlungseinheit 13 im Speicher 20 abgelegt. Ferner wird von Steuerschaltung 19 mittels des Steuersignals SI die Signalquelle 12 derart eingestellt, dass der dritte Wert I3 des Eingangssignals I an den Hallsensor 11 abgegeben wird, der wiederum den dritten Wert V3 des Ausgangssignals V bereitstellt. Der dritte Wert V3 des Ausgangssignals V wird im Speicher 20 abgelegt. Aus den vorgegebenen drei Werten I1, I2, I3 des Eingangssignals I und den gemessenen drei Werten V1, V2, V3 des Ausgangssignals V berechnet die Ermittlungseinheit 13 den Wert des Exponenten n und den Wert des Offsetfaktors k. Weiter berechnet die Ermittlungseinheit 13 den Wert der Rest-Offsetspannung VOFF beispielsweise beim ersten, zweiten oder dritten Wert I1, I2, I3 des Eingangssignals I oder einem weiteren vorgegebenen Wert Iv des Eingangssignals I und daraus den Wert des Magnetfeldsignals SB oder den Wert des Produktes aus dem Wert des Magnetfelds B und dem Wert der Empfindlichkeit S.

Die erste und die zweite Ausführungsform des Verfahrens beruhen auf der Annahme, dass sich der Wert des Magnetfelds B nur sehr geringfügig während der Dauer der Kalibrierphase ändert. Mit Vorteil wird die Rest-Offsetspannung VOFF um den Faktor 0,5 bis 0,01 gegenüber dem Wert der Rest-Offsetspannung VOFF, der bereits durch Anwendung der Current Spinning-Technik reduziert ist, weiter verringert. Mit Vorteil ist der Aufwand für die Durchführung der ersten und der zweiten Ausführungsform des Verfahrens gering gehalten; so wird beispielsweise keine Spule benötigt.

Beim niedrigsten Wert von den drei Werten I1, I2, I3 des Eingangssignals I wird die längste Messdauer und beim größten Wert von den drei Werten I1, I2, I3 des Eingangssignals I die kürzeste Messdauer eingestellt. Beim mittleren Wert der drei Werte I1, I2, I3 wird eine Messdauer zwischen der kürzesten und der längsten Messdauer eingestellt.

In einer alternativen Ausführungsform wird die Kalibrierung durchgeführt und anschließend verifiziert. Dazu werden während der Kalibrierphase zuerst der erste Wert I1 des Eingangssignals I erzeugt, der erste Wert V1 des Ausgangssignals V abgespeichert und anschließend der zweite Wert 12 des Eingangssignals I erzeugt. Zur Verifikation wird die Messung mit dem ersten Wert I1 des Eingangssignals I wiederholt und der dazugehörige neu bestimmte Wert V1' des Ausgangssignals V mit dem während der Kalibrierphase bestimmten ersten Wert V1 des Ausgangssignals V verglichen. Den Vergleich führt der Komparator 24 in der Ermittlungseinheit 13 durch. Stimmen die beiden Werte V1 und V1' überein, so kann angenommen werden, dass sich die Stärke des Magnetfelds B während der Kalibrierphase nicht deutlich verändert hat und die ermittelten Werte für den Offset-Faktor k und den Exponenten n in der darauf folgenden Betriebsphase verwendet werden können. Optional werden weitere Messungen als Kontrollmessungen durchgeführt. Mit Vorteil können so systematische Fehler aufgrund ungünstiger Frequenzkomponenten erkannt werden.

In einer Ausführungsform ist mindestens ein Wert des Eingangssignals I größer als 1 mA. In einer alternativen Ausführungsform ist mindestens ein Wert des Eingangssignals I größer als 2 mA.

Figur 1D zeigt ein Beispiel für Messergebnisse, die mit der ersten Ausführungsform des Verfahrens erzielt wurden. Dazu wurden 19 verschiedene Hallsensoren vermessen. Der Wert des Eingangssignals I betrug 2,25 mA. In Figur 1D ist zu jedem der 19 Hallsensoren eine gemäß der ersten Ausführungsform des Verfahrens berechnete Rest-Offsetspannung VOFF, eine gemessene Rest-Offsetspannung VOFFC sowie eine verbleibende Rest-Offsetspannung VOFFR angegeben. Die Werte VOFFC wurden ohne ein externes angelegtes Feld mit Ausnahme des Erdmagnetfelds gemessen, wobei das Erdmagnetfeld während der Messung nicht abgeschirmt wurde. Die Werte VOFF der berechneten Rest-Offsetspannungen wurden mit dem oben angegebenen Verfahren aus Messdaten extrahiert, die bei einem angelegten externen Magnetfeld von 1.6 mT bestimmt werden. Der Wert VOFFR ist die Differenz aus den gemessenen Werten VOFFC der Rest-Offsetspannung und den berechneten Werten VOFF der Rest-Offsetspannung und entspricht der Stärke des Erdmagnetfelds in der Messkammer. Figur 1D zeigt somit, dass eine Offset-Kalibrierung bei angelegtem externem Magnetfeld, hier von 1.6 mT, möglich ist.

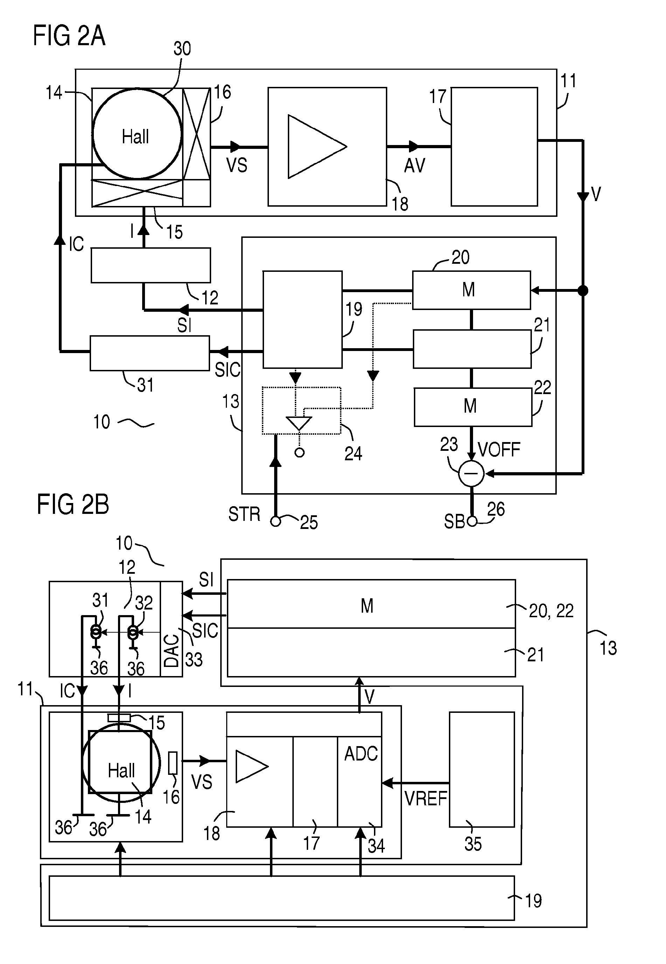

Figur 2A zeigt eine weitere beispielhafte Ausführungsform der Hallsensoranordnung. Die Hallsensoranordnung 10 gemäß Figur 2A ist eine Weiterbildung der in Figur 1A gezeigten Hallsensoranordnung. Zusätzlich umfasst die Hallsensoranordnung 10 eine Spule 30, welche mit dem Hallsensor 11 gekoppelt ist. Die Spule 30 ist auf dem Hallelement 14 angeordnet. Die Spule 30 ist derart angeordnet, dass das von der Spule 30 erzeugte Magnetfeld zum vom Hallelement 14 gemessenen Magnetfeld beiträgt. Weiter umfasst die Hallsensoranordnung 10 einen Stromgenerator 31, dessen Ausgang mit der Spule 30 verbunden ist. Ein weiterer Steuerausgang der Ermittlungseinheit 13 ist am Stromgenerator 31 angeschlossen. Die Steuerschaltung 19 ist ausgangsseitig mit dem Stromgenerator 31 verbunden.

Der Stromgenerator 31 stellt einen Spulenstrom IC bereit, der der Spule 30 zugeleitet wird. Das von der Spule 30 erzeugte Magnetfeld ist proportional zum Wert des Spulenstroms IC. Die Ermittlungseinheit 13 erzeugt ein weiteres Steuersignal SIC, das dem Stromgenerator 31 zugeleitet wird und den Wert des Spulenstroms IC steuert.

Figur 2B zeigt eine weitere beispielhafte Ausführungsform der Hallsensoranordnung, die eine Weiterbildung der in Figuren 1A und 2A gezeigten Hallsensoranordnungen ist. Die Signalquelle 12 umfasst eine Stromquelle 32, deren Ausgang mit dem Hallsensor 11 verbunden ist. Die Stromquelle 32 ist gesteuert realisiert. Weiter weist die Signalquelle 12 einen Digital-Analog-Wandler 33 auf. Die Stromquelle 32 bildet einen Stromausgang des Digital-Analog-Wandlers 33. Der Stromgenerator 31 ist ebenfalls als Stromquelle realisiert. Die Stromquelle des Stromgenerators 31 ist gesteuert implementiert. Die Stromquelle des Stromgenerators 31 stellt einen weiteren Ausgang des Digital-Analog-Wandlers 33 dar. Der Digital-Analog-Wandler 33 ist somit als zweikanaliger Digital-Analog-Wandler realisiert.

Die Auswerteschaltung 17 umfasst ein Tiefpassfilter. Weiter umfasst der Hallsensor 11 einen Analog-Digital-Wandler 34, der zwischen der Auswerteschaltung 17 und dem Ausgang des Hallsensors 11 angeordnet ist. Der Analog-Digital-Wandler 34 ist ausgangsseitig mit dem Signaleingang der Ermittlungseinheit 13 verbunden. Ferner weist die Hallsensoranordnung 10 eine Referenzquelle 35 auf. Die Referenzquelle 35 ist mit einem Referenzeingang des Analog-Digital-Wandlers 34 verbunden. Der Speicher 20 und der weitere Speicher 22 bilden in Figur 2B einen gemeinsamen Speicherblock. Der Speicher 20 und der weitere Speicher 22 weisen Speicherzellen zur Speicherung eines Spulenfaktors CS, verschiedene vorgegebene Werte I1, 12, 13, Iv des Eingangssignals I und/oder verschiedene vorgegebene Werte des Spulenstroms IC auf.

Die Steuerschaltung 19 ist ausgangsseitig mit der Eingangsschaltung 15, der Ausgangsschaltung 16, dem Verstärker 18 und dem Analog-Digital-Wandler 34 verbunden. Die Steuerschaltung 19 steuert somit die Stellung der Schalter der Eingangs- und der Ausgangsschaltung 15, 16 zur Durchführung der Current Spinning-Technik. Entsprechend der Signale an die Schalter der Eingangs- und der Ausgangsschaltung 15, 16 wird der Verstärker 18 eingestellt. Der Verstärker 18 ist als Chopping Amplifier realisiert. Weiter steuert die Steuerschaltung 19 den Analog-Digital-Wandler 34. Dadurch wird erreicht, dass erst nach Durchführung eines kompletten Zyklus gemäß der Spinning-Technik ein Messwert als Ausgangssignal V der Ermittlungseinheit 13 bereitgestellt wird. Die Referenzschaltung 15 stellt ein Referenzsignal VREF bereit, welches dem Analog-Digital-Wandler 34 zugeleitet wird.

In einer dritten Ausführungsform des Verfahrens wird die Abhängigkeit der Empfindlichkeit S(I) vom Eingangssignal I berücksichtigt. Die Abhängigkeit der Empfindlichkeit S(I) vom Eingangssignal I wird mittels der Spule 30 bestimmt. Die Spule 30 ist über dem Hallsensor 11 angeordnet. Aus der Änderung des Ausgangssignals V in Abhängigkeit vom Spulenstrom IC kann die Empfindlichkeit S(I) bei einem vorgegebenen Wert I des Eingangssignals gemäß folgender Gleichung ermittelt werden, wobei i die Werte eins bis vier annimmt, welche die vier verwendeten Richtungen des Stroms im Hallelement 14 gemäß der Current Spinning-Technik bezeichnen:

$$S(I) = \frac{\sum\limits_{i=1..4} (V_i^{+IC} - V_i^{-IC})}{4 \cdot I \cdot 2 \cdot IC \cdot CS},$$

wobei $V_i^{+IC}$ der Wert des Ausgangssignals bei einem positiven Spulenstrom und der i-ten Richtung, $V_i^{-IC}$ der Wert des Ausgangssignals bei einem negativen Spulenstrom und der i-ten Richtung, IC der Wert des Spulenstroms und CS der Wert des Spulenfaktors der Spule 30 ist. Die Ermittlung der Empfindlichkeit S(I) kann bei vorhandenem externem Magnetfeld durchgeführt werden. Bei jedem Wert I1, I2 des Eingangssignals I wird der Wert des Ausgangssignals V mit einem Wert 0 des Spulenstroms IC, bei einem positiven Wert sowie bei einem negativen Wert des Spulenstroms IC bestimmt. Die Absolutwerte des positiven und des negativen Werts des Spulenstroms IC sind identisch. Da die Ermittlungseinheit 13 nunmehr die Stromabhängigkeit der Empfindlichkeit S(I) berücksichtigt, wird ein genauer Wert des Magnetfeldsignals SB ermittelt.

Gemäß der dritten Ausführungsform des Verfahrens wird während der Kalibrierphase die Empfindlichkeit S(I) sowie das Ausgangssignal V bei dem ersten und dem zweiten Wert I1, I2 des Eingangssignals I mit Hilfe der Spule 30 bestimmt. Ein vorgegebener Wert für den Exponenten n wird verwendet. Somit kann mit der bereits oben beschriebenen Gleichung der Wert des Offsetfaktors k in der Berechnungseinheit 21 bestimmt werden:

$$k = \frac{V2 - V1 \cdot \dfrac{I2 \cdot S(I2)}{I1 \cdot S(I1)}}{I2^n - I1^{n-1} \cdot \dfrac{S(I2)}{S(I1)}},$$

Für die Messung während der Betriebsphase wird der erste oder der zweite Wert I1, I2 des Eingangssignals eingesetzt. Somit gibt beispielsweise die Signalquelle 12 den ersten Wert I1 des Eingangssignals I ab. Mit dem vorgegebenen Wert für den Exponenten n, dem ermittelten Wert des Offsetfaktors k sowie dem ermittelten Wert S(I1) oder S(I2) für die Empfindlichkeit S(I) beim ersten oder zweiten Wert I1, I2 des Eingangssignals I können anschließend in der Betriebsphase kontinuierlich die zeitabhängigen Werte des Magnetfeld B oder des Magnetfeldsignals SB mit folgenden Gleichungen bestimmt werden:

$$VOFF1 = k \cdot I1^n,$$

$$VOFF2 = k \cdot I2^n,$$

$$B = \frac{V1 - VOFF1}{I1 \cdot S(I1)} = \frac{V2 - VOFF2}{I2 \cdot S(I2)},$$

$$SB = V1 - VOFF1,$$

$$SB = V2 - VOFF2$$

Gemäß einer vierten Ausführungsform des Verfahrens werden in der Kalibrierphase mindestens für den ersten, zweiten und dritten Wert I1, 12, 13 des Eingangssignals I die entsprechenden Werte V1, V2, V3 des Ausgangssignals V bestimmt und ebenfalls beim ersten, zweiten und dritten Wert I1, 12, 13 des Eingangssignals I die drei Werte S(I1), S(I2), S(I3) der Empfindlichkeit S(I) mittels der Spule 30 ermittelt. Somit lässt sich aus nachfolgend angegebenen Gleichungen zuerst der Wert des Exponenten n und anschließend der Wert des Offset-faktors k bestimmen. Für die Berechnung wird das bereits angegebene iterative Berechnungsverfahren verwendet.

$$a \cdot I1^n + b \cdot I2^n + c \cdot I3^{n+1} = 0,$$

$$a = S(I3) \cdot I3 \cdot (V2 \cdot S(I3) \cdot I3 - V3 \cdot S(I2) \cdot I2),$$

$$b = S(I3) \cdot I3 \cdot (V3 \cdot S(I1) \cdot I1 - V1 \cdot S(I3) \cdot I3),$$

$$c = S(I3) \cdot (V1 \cdot S(I2) \cdot I2 - V2 \cdot S(I1) \cdot I1),$$

$$k = \frac{V2 - V1 \cdot \dfrac{I2 \cdot S(I2)}{I1 \cdot S(I1)}}{I2^n - I1^{n-1} \cdot \dfrac{S(I2)}{S(I1)}}$$

Drei oder mehr Werte des Eingangssignals I und die dazugehörenden Werte des Ausgangssignals V werden generiert.

Beispielsweise werden für die N Werte I1, 12, 13, ..., IN die N Werte V(I1), V(I2), V(I3), ..., V(IN) des Ausgangssignals V ermittelt. Zur iterativen Berechnung wird ausgehend von einem Startwert n-Start des Exponenten n der erste Wert VOFF1 der Rest-Offsetspannung aus dem ersten und dem zweiten Wert V1, V2 des Ausgangssignals V, der zweite Wert VOFF2 der Rest-Offsetspannung aus dem zweiten und dem dritten Wert V2, V3 des Ausgangssignals V sowie der N-1te Wert VOFF_N-1 der Offsetspannung aus dem N-1ten und dem Nten Wert V der Ausgangsspannung V ermittelt. Gemäß der Methode der kleinsten Fehlerquadrate wird der erste Wert n1 des Exponenten n wird berechnet. Mit dem so bestimmten ersten Wert n1 des Exponenten n wird die Extraktion des ersten Werts VOFF1 bis zum N-1ten Werts VOFF_N-1 der Rest-Offsetspannung VOFF wiederholt. Die iterativen Berechnungen werden weiter fortgesetzt. Das iterative Verfahren konvergiert mit Vorteil sehr schnell. Beispielsweise wird selbst von einem ungünstigen Ausgangswert wie n = 1,1 das Ergebnis n = 3,0 in zwei bis vier Iterationszyklen erreicht.

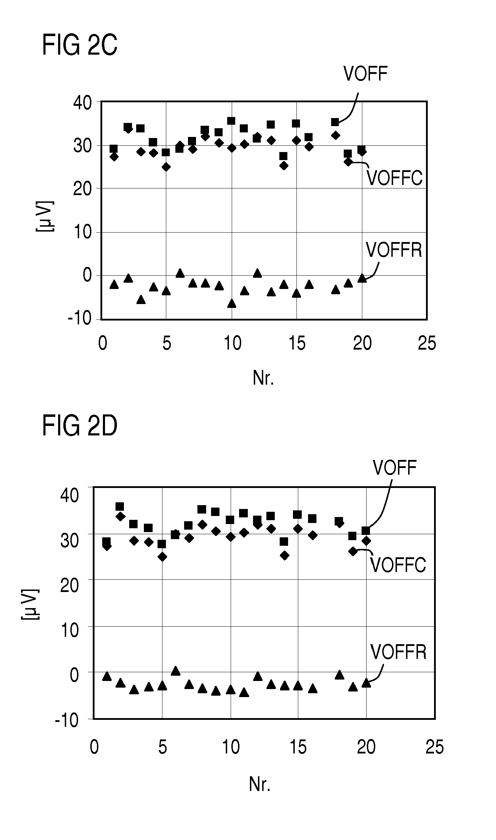

Figur 2C zeigt beispielhafte Messergebnisse, die mit der dritten Ausführungsform des Verfahrens bestimmt wurden. Dabei wurde ein Wert n = 3.0 für den Exponenten n angenommen. Der Wert des Eingangssignals I betrug 2,25 mA.

Figur 2D hingegen zeigt ein Beispiel für Messergebnisse, die mit der vierten Ausführungsform des Verfahrens erzielt wurden. Gemäß Figur 2D ist der ermittelte Wert des Exponenten n bei den verschiedenen Exemplaren der Hallsensoranordnungen 10 unterschiedlich und liegt in einem Bereich von 2,88 bis 3,17. In Figuren 2C und 2D sind zu jedem der 19 Exemplare der Hallsensoranordnung die zugehörigen Werte der gemäß dem oben beschriebenen Verfahren berechneten Rest-Offsetspannung VOFF, der gemessenen Rest-Offsetspannung VOFFC, und der übrig bleibenden Rest-Offsetspannung VOFFR angegeben. Wie bereits bei Figur 1D erläutert, wurden die Werte VOFFC gemessen, als ausschließlich das Erdmagnetfeld den Hallsensor 11 beeinflusste. Die Werte VOFF der berechneten Rest-Offsetspannungen wurden mit der dritten und vierten Ausführungsform des Verfahrens aus Messdaten bei einem externen Magnetfeld von 1,6 mT extrahiert. Der Wert VOFFR ist die Differenz aus den gemessenen Werten VOFFC und den berechneten Werten VOFF und entspricht der Stärke des Erdmagnetfelds in der Messkammer. Mit Vorteil wird mittels der dritten und der vierten Ausführungsform des Verfahrens eine besonders hohe Genauigkeit bei der Bestimmung des Magnetfelds B erzielt.

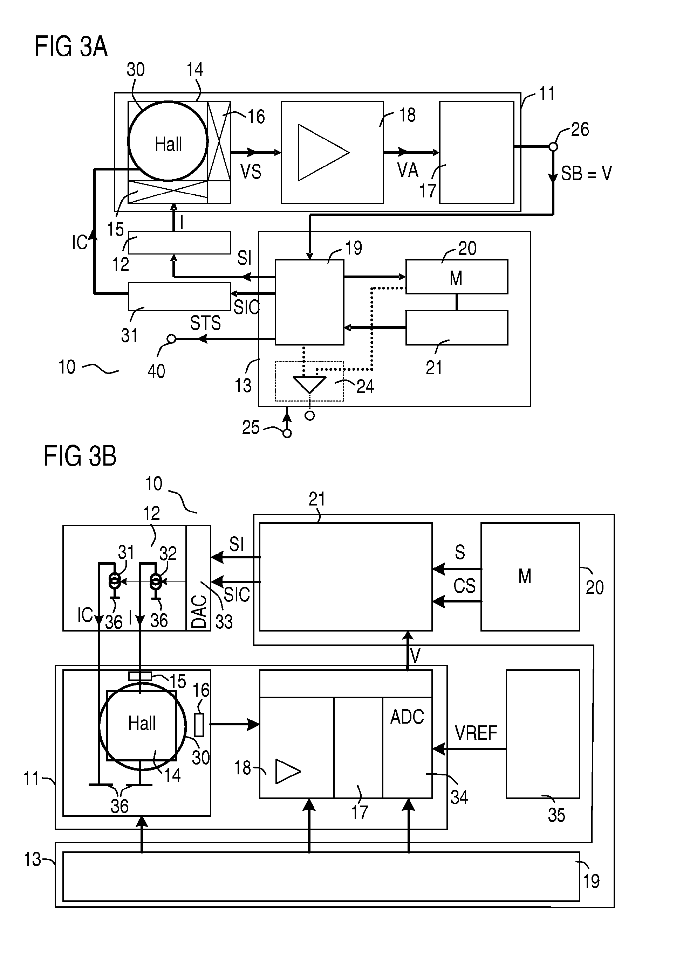

Figur 3A zeigt eine weitere beispielhafte Ausführungsform der Hallsensoranordnung. Die Hallsensoranordnung 10 gemäß Figur 3A ist eine Weiterbildung der in den Figuren 1A, 2A und 2B gezeigten Ausführungsformen. Die Ermittlungseinheit 13 weist einen Statussignalausgang 40 auf. Am Statussignalausgang 40 gibt die Ermittlungseinheit 13 ein Statussignal STS ab. Das Statussignal STS hat einen ersten Wert während der Betriebsphase und einen zweiten Wert während der Kalibrierphase der Hallsensoranordnung 10. Mit dem Statussignal STS kann somit angegeben werden, ob die iterative Kalibrierung in der Kalibrierphase abgeschlossen ist. Das am Ausgang des Hallsensors 11 abgreifbare Ausgangssignal V entspricht bereits dem Magnetfeldsignal SB. Das Ausgangssignal V wird der Steuerschaltung 19 der Ermittlungseinheit 13 zugeleitet. Das Ausgangssignal V ist bereits frei vom Rest-Offsetwert VOFF, sobald das Statussignal STS angibt, dass die Kalibrierphase erfolgreich abgeschlossen ist. Der Subtrahierer 23 kann somit in der Ausführungsform gemäß Figur 3A entfallen.

Figur 3B zeigt eine weitere beispielhafte Ausführungsform der Hallsensoranordnung, die eine Weiterbildung der in den Figuren 1A, 2A, 2B und 3A gezeigten Ausführungsformen ist. Der Speicher 20 weist Speicherzellen zur Speicherung der Empfindlichkeit S und des Spulenfaktors CS auf. Die Berechnungseinheit 21 bestimmt den Wert des Exponenten n, den Offsetfaktor k sowie den Wert des Spulenstroms IC. Der Spulenstrom IC weist somit keinen vorgegebenen Wert auf. Der Spulenstrom IC hat einen variablen Wert. Der Spulenstrom IC wird mittels des Digital-Analog-Wandlers 33 und des Stromgenerators 31 bereitgestellt. Der Verstärker 18, die Auswerteschaltung 17 und der Analog-Digital-Wandler 34 können zusammen als Kanal bezeichnet werden. Die Auswerteschaltung 17 dient der Offsetreduzierung, die aufgrund der Current Spinning-Technik erzielt wird. Die Berechnungsschaltung 21 berechnet den Wert des Exponenten n und den Wert des Offsetfaktors k, um den Wert des Spulenstroms IC zu bestimmen.

Gemäß einer fünften Ausführungsform des Verfahrens ist das erhaltene Ausgangssignal V frei von der Rest-Offsetspannung VOFF nach der Kalibrierphase. Die Kalibrierphase kann auch als Startphase bezeichnet sein. Dazu wird die Rest-Offsetspannung VOFF mittels eines Magnetfelds kompensiert, welches mittels der Spule 30 erzeugt wird. Der Wert des Spulenstroms IC hängt vom Wert des Eingangssignals I des Hallsensors 11 ab und wird mittels einer iterativen Methode während der Kalibrierphase bestimmt. Während in den ersten vier Ausführungsformen des Verfahrens vom gemessenen Wert des Ausgangssignals V die Rest-Offsetspannung VOFF abgezogen wird, kompensiert in der fünften Ausführungsform des Verfahrens das Magnetfeld der Spule 30 die Rest-Offsetspannung VOFF und ist das Ausgangssignal V direkt proportional zum Magnetfeld B.

Für jede Bestimmung des Magnetfelds B wird das Ausgangssignal V beim ersten, zweiten und dritten Wert I1, I2, I3 des Eingangssignals I gemessen. Somit wird eine quasi andauernde Rekalibrierung durchgeführt. Alternativ wird in der Kalibrierphase der Hallsensor 11 kalibriert und anschließend in der Betriebsphase des Ausgangssignal V ausschließlich bei einem Wert, also etwa dem ersten, zweiten oder dritten Wert I1, I2, I3 des Eingangssignals I bestimmt. Eine Rekalibrierung kann gemäß einem der oben beschriebenen Verfahren ausgelöst werden.

Gemäß der fünften Ausführungsform des Verfahrens wird der Hallsensor 11 mit drei unterschiedlichen Werten I1, I2, I3 des Eingangssignals I beaufschlagt. Das Eingangssignal I ist als durch das Hallelement 14 fließender Strom realisiert. Bei allen drei Werten I1, I2, I3 des Eingangssignals I wird eine Rest-Offsetspannung VOFF zurückgeregelt, dadurch dass der Spulenstrom IC durch die Spule 30 fließt. Wenn die Rest-Offsetspannung VOFF exakt durch das Magnetfeld der Spule 30 kompensiert ist, steigt das Ausgangssignal V linear mit dem Eingangssignal I an. Für diese Bedingung können der Wert des Exponenten n und der Wert des Offsetfaktors k analytisch von der Ermittlungseinheit 13 berechnet werden. Das Verfahren beginnt mit einem Wert Null des Spulenstroms IC in einem ersten Arbeitspunkt und ermittelt die nötige Werte des Spulenstroms IC für den zweiten und dritten Arbeitspunkt derart, dass eine lineare Beziehung zwischen dem Ausgangssignal V und dem Eingangssignal I erreicht wird. Im ersten Arbeitspunkt nimmt das Eingangssignal I den ersten Wert I1, im zweiten Arbeitspunkt das Eingangssignal I den zweiten Wert I2 und im dritten Arbeitspunkt des Eingangssignal I den dritten Wert I3 an. Aus dem Wert des Spulenstroms IC werden der Wert des Exponenten n und der Wert des Offsetfaktors k berechnet und dienen als Parameter für die Berechnung des Spulenstroms IC im ersten Arbeitspunkt im nächsten Iterationsdurchlauf. Folglich werden der Wert des Exponenten n und der Wert des Offsetfaktors k in iterativer Weise ermittelt.

Wenn die Rest-Offsetspannung VOFF durch das Magnetfeld der Spule 30 kompensiert ist, sind folgende Gleichungen erfüllt:

$$n = \frac{\ln \dfrac{\alpha 3 \cdot \gamma 3}{\alpha 2 \cdot \gamma 2}}{\ln \dfrac{\alpha 3}{\alpha 2}} = 1 + \frac{\ln \gamma 3 - \ln \gamma 2}{\ln \alpha 3 - \ln \alpha 2},$$

$$k = -\frac{S \cdot kc \cdot \gamma 2 \cdot I1}{(I1 \cdot \alpha 2)^{n-1}} = \frac{S \cdot kc \cdot \gamma 2 \cdot I1}{(I1 \cdot \alpha 2)^{(\ln \gamma 2 - \ln \gamma 3)/(\ln \alpha 2 - \ln \alpha 3)}},$$

$$VOFF = k \cdot I2^n,$$

$$V2 = \alpha 2 \cdot V1,$$

$$V3 = \alpha 3 \cdot V1,$$

$$I2 = \alpha 2 \cdot I1,$$

$$I3 = \alpha 3 \cdot I1,$$

$$IC2 = \gamma 2 \cdot I1,$$

$$IC3 = \gamma 3 \cdot I1$$

Die Bedingung für den Offset 0 ist somit:

$$k \cdot I1^n + IC1 \cdot kc \cdot S \cdot I1 = 0,$$

$$IC1 = -\frac{I1^{n-1} \cdot k}{S \cdot kc}$$

Dabei ist CS der Spulenfaktor, S die Empfindlichkeit, V1 der Wert des Ausgangssignals V beim ersten Wert I1 des Eingangssignals I, V2 der zweite Wert des Ausgangssignals V beim zweiten Wert 12 des Eingangssignals I, V3 der dritte Wert des Ausgangssignals V beim dritten Wert 13 des Eingangssignals I, IC1 der erste Wert des Spulenstroms, IC2 der zweite Wert des Spulenstroms und IC3 der dritte Wert des Spulenstroms.

Die iterative Regelschleife weist folgende Elemente auf:

Der Wert des Spulenstroms IC wird auf einen Startwert Null eingestellt, so dass gilt:

$$Ic1 = 0$$

Die Abarbeitung der Schleife fängt mit folgendem Schleifenanfang an:

Einstellen des ersten Arbeitspunktes mittels Einstellen des ersten Wertes I1 des Eingangssignals I Speichern des ersten Werts V1 des Ausgangssignals V

Einstellen des zweiten Arbeitspunktes mittels Einstellen des zweiten Werts 12 des Eingangssignals I. Der zweite Wert 12 des Eingangssignals I ist dabei um den Faktor $\alpha 2$ größer als der erste Wert I1 des Eingangssignals, so dass gilt:

$$I2 = \alpha 2 \cdot I1$$

Der zweite Wert IC2 des Spulenstroms IC wird nun so eingestellt, dass der zweite Wert V2 des Ausgangssignals V folgende Beziehung erfüllt:

$$V2 = \alpha 2 \cdot V1$$

Dabei wird der Faktor $\gamma 2$ ermittelt:

$$IC2 = \gamma 2 \cdot I1$$

Einstellen des dritten Arbeitspunktes mittels Einstellen des dritten Werts 13 des Eingangssignals I. Der dritte Wert 13 des Eingangssignals I ist dabei um den Faktor $\alpha 3$ größer als der erste Wert I1 des Eingangssignals I, so dass gilt:

$$I3 = \alpha 3 \cdot I1$$

Der dritte Wert IC3 des Spulenstroms IC wird nun so eingestellt, dass der dritte Wert V3 des Ausgangssignals V folgende Beziehung erfüllt:

$$V3 = \alpha 3 \cdot V1$$

Dabei wird der Faktor $\gamma 3$ ermittelt:

$$IC3 = \gamma 3 \cdot I1$$

$\alpha 2$ und $\alpha 3$ sind dabei vorgegebene Werte. Die Werte für $\gamma 2$ und $\gamma 3$ werden wie oben angegeben ermittelt. Aus den Werten für $\alpha 2$, $\alpha 3$, $\gamma 2$ und $\gamma 3$ kann der Wert des Exponenten n und darauf der Wert des Offsetfaktors k gemäß folgenden Gleichungen errechnet werden:

$$n = \frac{\ln \dfrac{\alpha 3 \cdot \gamma 3}{\alpha 2 \cdot \gamma 2}}{\ln \dfrac{\alpha 3}{\alpha 2}},$$

$$k = -\frac{S \cdot kc \cdot \gamma 2 \cdot I1}{(I1 \cdot \alpha 2)^{n-1}},$$

Der erste Wert des Spulenstroms IC1 kann nun aus folgender Gleichung berechnet und eingestellt werden. Mit dem Wert IC1 für den Spulenstrom wird die Rest-Offsetspannung VOFF kompensiert.

$$IC1 = -\frac{I1^{n-1} \cdot k}{S \cdot kc}$$

Hier wird die Schleife beendet.

Obige Schleife wird mehrfach durchlaufen, bis ein Konvergenzkriterium erfüllt ist.

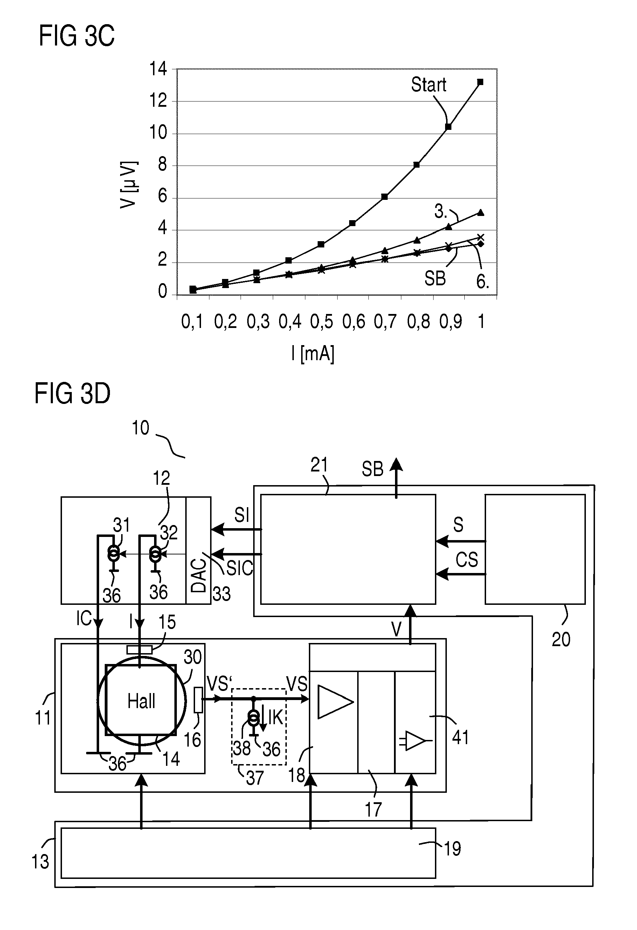

Figur 3C zeigt beispielhafte Ergebnisse, die mit der fünften Ausführungsform des Verfahrens erreicht wurden. Dabei ist die Ausgangsspannung V über dem Eingangssignal I aufgetragen. Die oberste Kurve zeigt das Ausgangssignal V ohne Kompensation, das heißt bei einem Wert Null des Spulenstroms IC. Darunter liegen eine Kurve, die beim dritten Iterationsschritt erzielt wurde, sowie eine Kurve, die beim sechsten Iterationsschritt erzielt wurde. Weiter ist das Magnetfeldsignal SB angegeben, das einem idealen Signal entspricht. Der Wert des Magnetfeldsignals SB hängt linear vom Wert des Eingangssignal I ab. Das Ausgangssignal V beim sechsten Iterationsschritt ist bereits sehr nahe zum idealen Signal. Der Wert des Magnetfelds betrug etwa 50 $\mu$T. Die Berechnungen wurden mit Testdaten durchgeführt.

Figur 3D zeigt eine weitere beispielhafte Ausführungsform der Hallsensoranordnung 10, die eine Weiterbildung der in den Figuren 1A, 2A, 2B, 3A und 3B gezeigten Hallsensoranordnungen ist. Zwischen dem Hallelement 14 und dem Verstärker 18 ist eine Kompensationseinheit 37 angeordnet. Die Kompensationseinheit 37 umfasst eine Kompensationsstromquelle 38. Die Kompensationsstromquelle 38 ist an den Ausgang der Ausgangsschaltung 16 angeschlossen. Der Hallsensor 11 weist einen Nullpunktdetektor 41 auf. Der Nullpunktdetektor 41 ist zwischen der Auswerteschaltung 17 und dem Ausgang des Hallsensors 11 angeordnet. Der Nullpunktdetektor 41 ist ausgangsseitig mit dem Eingang der Ermittlungseinheit 13 verbunden. Der Nullpunktdetektor 41 umfasst einen Komparator. Die Auswerteschaltung 17 ist als Tiefpassfilter realisiert. Der Verstärker 18 ist als Autozeroverstärker ausgebildet.

Das Ausgangssignal V des Hallsensors 11 weist somit die logischen Werte Null und Eins auf. Das Magnetfeldsignal SB wird von der Berechnungseinheit 21 bereitgestellt. Ein Kompensationsstrom IK fließt durch die Kompensationsstromquelle 38. Die Kompensationseinheit 37 beseitigt einen Teil des Offsets. Der Bereich für die Werte des Spulenstroms IC kann klein gehalten werden, dadurch dass der Offset mittels der Kompensationseinheit 37 reduziert ist.

Eine sechste Ausführungsform des Verfahrens wird mit Hilfe der in Figur 3D dargestellten Hallsensoranordnung 10 realisiert. Gemäß der sechsten Ausführungsform kann das Magnetfeld B durch den Spulenstrom IC, welcher durch die Spule 30 fließt, bestimmt werden. Die Hallsensoranordnung 10 kann als elektronischer Kompass verwendet werden. Die sechste Ausführungsform des Verfahrens eignet sich besonders für die Bestimmung von kleinen Werten des Magnetfelds B.

Für die sechste Ausführungsform des Verfahrens werden der Wert des Exponenten n und der Wert des Offsetfaktors k wie oben angegeben extrahiert. Ein erster Arbeitspunkt wird eingestellt. Beispielsweise wird der dritte Wert 13 des Eingangssignals von der Signalquelle 12 abgegeben und dem Hallsensor 11 zugeleitet. Der Wert des Spulenstroms IC wird nun so eingestellt, dass der dritte Wert V3 des Ausgangssignals V Null erreicht. Vom Wert des Spulenstroms IC wird nun der Anteil abgezogen, der zur Kompensation des Offsets erforderlich ist. Der übrige Wert des Spulenstroms IC ist somit proportional zum Wert des Magnetfelds B. Daraus lässt sich der Wert des Magnetfelds B berechnen.

Der Verstärker 18 weist eine steile Übersetzungskennlinie auf. Eine kleine Änderung des Sensorsignals VS am Eingang des Verstärkers 18 führt zu einer großen Änderung des verstärkten Sensorsignals AV. Die Berechnungseinheit 21 berechnet den Wert des Exponenten n und den Wert des Offsetfaktors k, den Wert der Offsetspannung VOFF oder den Wert des Spulenstroms IC, welcher zur Offsetspannung VOFF korrespondiert. Weiter stellt die Berechnungsschaltung 21 die Nullpunktbedingung durch Einstellen des geeigneten Werts des Spulenstroms IC ein.

Der Wert des Spulenstroms IC setzt sich gemäß folgender Gleichung aus dem Wert IB, der linear vom Wert des Eingangssignals I abhängt, und dem Wert ICOFF, welcher zur Kompensation der Offsetspannung dient, zusammen:

$$IC = IB + ICOFF$$

Der Wert IB ist proportional zum Wert des Magnetfelds B. Die Messung des Magnetfelds hängt dann von der Empfindlichkeit S, dem Spulenfaktor CS und dem Wert des Spulenstroms IC ab. Der Wert der Empfindlichkeit S und des Spulenfaktors CS können während eines Produktionstests bestimmt werden. Die Werte können als vorgegebene Parameter während der gesamten Lebensdauer der Hallsensoranordnung 11 verwendet werden. Der Spulenstrom IC weist mit Vorteil einen besseren dynamischen Bereich als der Kanal auf, da der Kanal die Aufgabenstellung zu bewältigen hat, dass die Offsetspannung des Hallelements 14 größer als das Ausgangssignals V aufgrund eines kleinen Wertes des Magnetfelds B ist.

Gemäß dem Verfahren wird bei verschiedenen Werten I1, 12, 13 des Eingangssignals I ein Spulenstrom IC der Spule 30 zugeleitet. Der Spulenstrom IC wird so eingestellt, dass die Nullpunktbedingung vom Hallsensor 11 erreicht wird. Das heißt, dass das Ausgangssignal V näherungsweise Null ist. Der Wert des Spulenstrom IC hängt vom Magnetfeld B und vom restlichen Offset ab, welcher in einem vorangegangenen Iterationsschritt berechnet wurde. Das magnetfeldabhängige Signal IB kann durch Subtraktion des restlichen Offsets vom Wert des Spulenstroms IC berechnet werden. Mit Vorteil ist der Kanal auf einen Nullpunktdetektor reduziert. Vorteilhafterweise ist es nicht notwendig, dass der Verstärker 18 im Kanal eine hohe Linearität der Verstärkungskennlinie aufweist. Mit Vorteil hängt die Messgenauigkeit vor allem vom Digital-Analog-Wandler 33 ab, so dass mit geringem Aufwand eine hohe Genauigkeit erreicht werden kann. Mit Vorteil kann die Kalibration bei einem angelegten externen Magnetfeld mit unbekannter Magnetfeldstärke durchgeführt werden.

In einer bevorzugten Ausführungsform wird das Ausgangssignal V nach Durchführung der Current Spinning-Technik bereitgestellt. Der Rest-Offsetwert ist somit bereits gering. Daher sind nur niedrige Werte für den Spulenstrom IC notwendig. Es ist ausreichend, die Spule 30 für geringe Ströme auszulegen.

In einer Ausführungsform umfasst der Hallsensor 11 zusätzlich zu den in Figur 3D gezeigten Komponenten einen Analog-Digital-Wandler. Der Analog-Digital Wandler ist parallel zum Nullpunktdetektor 41 angeordnet. Mit Vorteil kann auf eine Referenzspannungsquelle verzichtet werden, da der Analog-Digital-Wandler ausschließlich verwendet wird, um den Wert des Exponenten n und den Wert des Offsetfaktors k zu bestimmen. Dabei ist eine relative Genauigkeit ausreichend.

In einer alternativen, nicht gezeigten Ausführungsform ist die Spule 30 mit dem Hallsensor 11 über einen Strompfad gekoppelt. Dabei kann der Spulenstrom IC zusätzlich auch als Eingangssignal I für das Hallelement 14 eingesetzt werden. Somit kann der Spulenstrom IC als Eingangssignal I durch den Hallsensor 11 fließen. Der Spulenstrom IC fließt sowohl durch die Spule 30 als auch durch das Hallelement 14. Somit wird mit Vorteil ein Stromverbrauch reduziert.

In einer alternativen, nicht gezeigten Ausführungsform umfasst die Hallsensoranordnung 10 einen Temperatursensor. Die Temperatur der Hallsensoranordnung 10 wird mittels des Temperatursensors gemessen. Zur Korrektur ist der Temperaturkoeffizient der Empfindlichkeit S im Speicher 20 gespeichert. Somit kann eine Temperaturkompensation durchgeführt werden.

In einer alternativen, nicht gezeigten Ausführungsform weist der Hallsensor 11 das Hallelement 14 sowie ein weiteres Hallelement auf. Das Hallelement 14 und das weitere Hallelement können gemäß dem Prinzip "Offsetreduktion durch paarweise Zusammenschalten" miteinander verbunden sein.

In einer alternativen Ausführungsform ist der Nullpunktdetektor 41 als Fensterkomparator ausgebildet. Der Fensterkomparator gibt als Ausgangssignal V an, ob das Signal am Eingang des Nullpunktdetektors 41 kleiner als ein unterer Schwellwert, zwischen dem unteren Schwellwert und einem oberen Schwellwert oder größer als der obere Schwellwert ist. Der untere Schwellwert hat einen negativen und der obere Schwellwert einen positiven Wert. Der obere und der untere Schwellwert sind nahe bei 0 Volt.

Optional kann die Kompensationseinheit 37 weggelassen werden. Der Ausgang der Ausgangsschaltung 16 ist dann direkt an den Eingang des Verstärkers 18 angeschlossen.

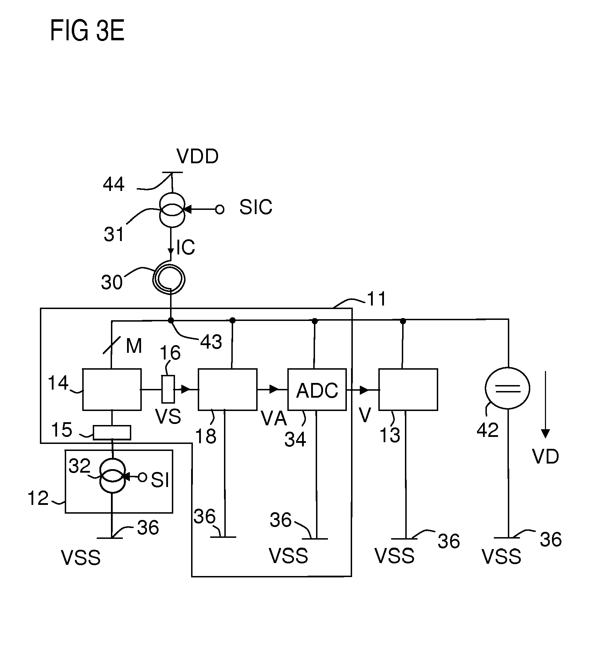

Figur 3E zeigt eine weitere beispielhafte Ausführungsform der Hallsensoranordnung 10, die eine Weiterbildung der in den Figuren 1A, 2A, 2B, 3A, 3B und 3D gezeigten Hallsensoranordnungen ist. Die Hallsensoranordnung 10 weist eine Spannungsquelle 42 auf, welche mit den Versorgungsanschlüssen des Hallsensors 11 und der Ermittlungseinheit 13 verbunden ist. Die Spannungsquelle 42 ist als Konstantspannungsquelle realisiert. Die Spannungsquelle 42 ist über den Hallsensor 11 und die Signalquelle 12 mit einem Bezugspotentialanschluss 36 verbunden. Dabei ist die Signalquelle 12, das Hallelement 14 und die Eingangsschaltung 15 zwischen einen Ausgang der Spannungsquelle 42 und dem Bezugspotentialanschluss 36 angeordnet. Weiter ist ein Knoten 43 zwischen dem Hallsensor 11 und der Spannungsquelle 42 über eine Serienschaltung, umfassend die Spule 30 und den Stromgenerator 31, mit einem Versorgungsspannungsanschluss 44 gekoppelt. Das Hallelement 14 ist über die Ausgangsschaltung 16, den Verstärker 18 und den Analog-Digital-Wandler 34 mit dem Signaleingang der Ermittlungseinheit 13 verbunden.

Die Spannungsquelle 42 stellt ausgangsseitig eine Versorgungsspannung VD bereit. Die Versorgungsspannung VD wird dem Hallsensor 11 und der Ermittlungseinheit 13 zu deren Spannungsversorgung zugeleitet. Am Bezugspotentialanschluss 36 ist ein Bezugspotential VSS abgreifbar. Am Versorgungsspannungsanschluss 44 liegt eine weitere Versorgungsspannung VDD an. Der vom Stromgenerator 31 bereitgestellte Spulenstrom IC fließt vom Versorgungsspannungsanschluss 44 über den Knoten 43 zum Hallsensor 11 und damit zum Hallelement 14. Die Spannungsquelle 42 dient dabei als Lastausgleich. Mit Vorteil kann somit der Spulenstrom IC teilweise oder vollständig durch das Hallelement 14 fließen. Damit ist der Wirkungsgrad der Hallsensoranordnung 10 erhöht.

In einer Ausführungsform umfasst der Hallsensor 11 eine erste Anzahl M Hallelemente. Dies ist durch die Anzahl M von Leitungen zwischen dem Knoten 43 und dem Hallelement 14 in Figur 3E angedeutet.

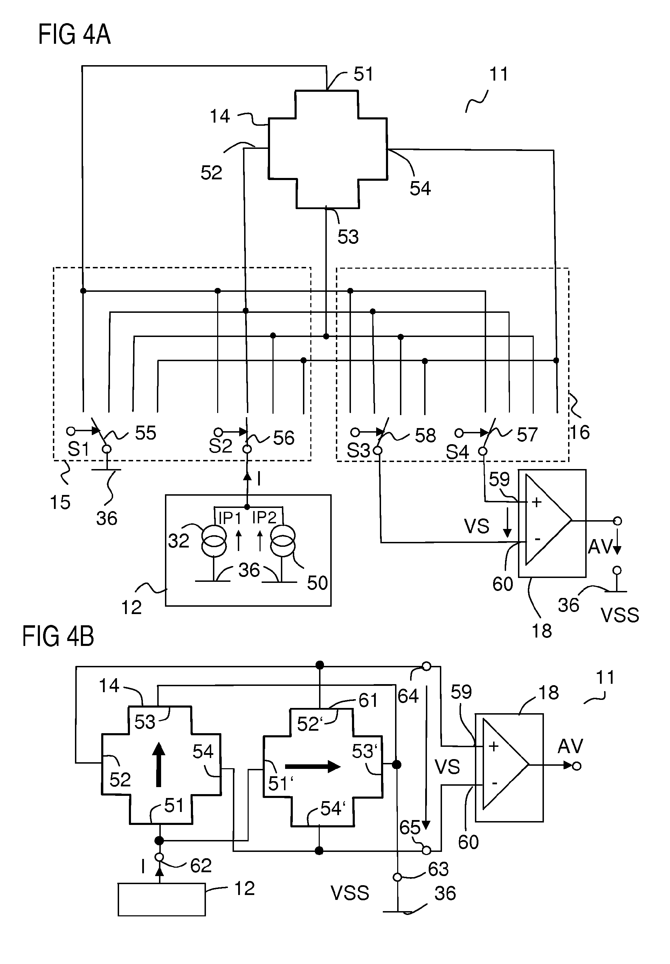

Figur 4A zeigt eine beispielhafte Ausführungsform von Details einer Hallsensoranordnung 10, die eine Weiterbildung der in den obigen Figuren gezeigten Hallsensoranordnungen ist. Die Signalquelle 12 umfasst die Stromquelle 32 und eine weitere Stromquelle 50. Die Stromquelle 32 und die weitere Stromquelle 50 sind parallel geschaltet. Ein Ausgang der Stromquelle 32 und ein Ausgang der weiteren Stromquelle 50 sind mit dem Ausgang der Signalquelle 12 verbunden.

Das Hallelement 14 weist einen ersten, zweiten, dritten und vierten Anschluss 51 bis 54 auf. Das Hallelement 14 ist symmetrisch realisiert. Der erste Anschluss 51 liegt dem dritten Anschluss 53 gegenüber. Entsprechend liegt der zweite Anschluss dem vierten Anschluss 55 gegenüber. Die Eingangsschaltung 15 umfasst einen ersten und einen zweiten Multiplexer 55, 56. Ebenso umfasst die Ausgangsschaltung 16 einen dritten und einen vierten Multiplexer 57, 58. Der erste, zweite, dritte und vierte Multiplexer 55 bis 58 weisen jeweils vier Eingänge auf, die mit dem ersten, zweiten, dritten und vierten Anschluss 51 bis 54 des Hallelements 14 gekoppelt sind. Ein Ausgang des ersten Multiplexers 55 ist an den Bezugspotentialanschluss 36 angeschlossen. Ein Ausgang des zweiten Multiplexers 56 ist über den Eingang des Hallsensors 11 an den Ausgang der Signalquelle 12 angeschlossen. Ein Ausgang des dritten Multiplexers 57 und ein Ausgang des vierten Multiplexers 58 sind mit dem Verstärker 18 gekoppelt. Der Verstärker 18 weist einen ersten und einen zweiten Eingang 59, 60 auf. Der erste Eingang 59 ist an den Ausgang des dritten Multiplexers 57 und der zweite Eingang 60 ist an den Ausgang des vierten Multiplexers 58 angeschlossen.

Die Stromquelle 32 und die weitere Stromquelle 50 sind jeweils als Konstantstromquellen implementiert. Die Stromquelle 32 und die weitere Stromquelle 50 sind jeweils getrennt einschaltbar und ausschaltbar. Die Stromquelle 32 gibt einen ersten Stromwert IP1 ab, der dem ersten Wert I1 des Eingangssignals I entspricht. Zur Erzeugung des ersten Werts I1 des Eingangssignals I wird somit die Stromquelle 32 eingeschaltet. Die weitere Stromquelle 50 gibt einen zweiten Stromwert IP2 ab. Die Summe aus dem ersten und dem zweiten Stromwert IP1, IP2 entspricht dabei dem zweiten Wert 12 des Eingangssignals I. Zur Erzeugung des zweiten Werts 12 des Eingangssignals I werden somit die Stromquelle 32 und die weitere Stromquelle 50 eingeschaltet. Damit erzeugt die Signalquelle 12 den ersten und den zweiten Wert I1, 12 des Eingangssignals I gemäß der ersten Ausführungsform des Verfahrens.

Die nicht gezeigte Ermittlungseinheit 13 stellt vier Multiplexersteuersignale S1 bis S4 bereit, die dem ersten, zweiten, dritten und vierten Multiplexer 55 bis 58 zugeleitet werden. Mittels der vier Multiplexer 55 bis 58 wird die Current Spinning-Technik, auch Current Spinning-Verfahren oder Strom-Drehverfahren genannt, implementiert. Ein Zyklus der Current Spinning-Technik weist mindestens zwei Phasen auf. Zwei gegenüberliegende Anschlüsse des Hallelements 14 werden über den ersten und den zweiten Multiplexer 55, 56 mit dem Bezugspotentialanschluss 36 beziehungsweise mit dem Ausgang der Signalquelle 12 gekoppelt. Entsprechend werden die beiden weiteren Anschlüsse des Hallelements 14 über den dritten und den vierten Multiplexer 57, 58 mit dem ersten und dem zweiten Eingang 59, 60 des Verstärkers 18 gekoppelt. Das Hallelement 14 ist für ein Magnetfeld senkrecht zur Oberfläche empfindlich. Das Ausgangssignal V des Hallsensors 11 wird erst nach vollständigem Durchlaufen der Phasen eines Zyklusses der Current Spinning-Technik bereitgestellt. Während der Phasen eines Zykluses der Current Spinning-Technik ist der Wert des Eingangssignals I konstant. Zur Bestimmung des Ausgangssignals V beim ersten Wert I1 des Eingangssignals I werden alle Phasen des Zyklusses gemäß der Current Spinning-Technik durchlaufen. Entsprechend werden für die Ermittlung des Ausgangssignals V bei dem zweiten und/oder dem dritten Wert 12, 13 des Eingangssignals I ebenfalls jeweils die Phasen eines Zyklusses der Current Spinning-Technik vollständig durchlaufen.

Ein Zyklus kann beispielsweise vier Phasen aufweisen. Mittels der Current Spinning-Technik wird erzielt, dass der Stromfluss im Hallelement 14 vier unterschiedliche Richtungen annimmt. Der Betrag des Sensorsignals VS ist ohne vorhandenem Offset in allen vier Phasen der Current Spinning-Technik gleich. In den vier Phasen eines Zyklusses ist somit jeder der vier Anschlüsse 51 bis 54 des Hallelements 14 phasenweise einmal mit dem Ausgang der Signalquelle 12, dem Bezugspotentialanschluss 36, dem ersten Eingang 59 und dem zweiten Eingang 60 des Verstärkers 18 verbunden.

Das Sensorsignal VS ist als differentielles Signal realisiert. Das Sensorsignal VS kann zwischen zwei Anschlüssen des Hallelements 14 abgegriffen werden. Das Sensorsignal VS wird dem ersten und dem zweiten Eingang 59, 60 des Verstärkers 18 zugeführt. Der Verstärker 18 wandelt das Sensorsignal VS in ein verstärktes Sensorsignal AV um. Das verstärkte Sensorsignal AV ist auf das Bezugspotential VSS am Bezugspotentialanschluss 36 bezogen. Bevorzugt wird eine der sechs oben geschilderten Ausführungsformen des Verfahrens nach dem vorgeschlagenen Prinzip zusätzlich zur Current Spinning-Technik durchgeführt. Die Kombination der Current Spinning-Technik und einer der erläuterten sechs Ausführungsformen des Verfahrens bewirkt eine hohe Genauigkeit der Magnetfeldbestimmung. In einer alternativen Ausführungsform entspricht der zweite Stromwert IP2 dem zweiten Wert 12 des Eingangssignals. Zur Erzeugung des ersten und des zweiten Werts I1, 12 des Eingangssignals I werden somit die Stromquelle 32 und die weitere Stromquelle 50 einzeln eingeschaltet.

In einer Weiterbildung der alternativen Ausführungsform werden die Stromquelle 32 und die weitere Stromquelle 50 gleichzeitig eingeschaltet. Die Summe aus dem ersten und dem zweiten Stromwert IP1, IP2 entspricht dabei dem dritten Wert 13 des Eingangssignals I. Somit können effizient mit zwei Stromquellen 32, 50 die drei verschiedenen Werte I1, 12, 13 des Eingangssignals I generiert werden.

In einer alternativen, nicht gezeigten Ausführungsform umfasst die Signalquelle 12 eine zusätzliche Stromquelle, deren Ausgang mit dem Ausgang der Signalquelle 12 verbunden ist. In einer alternativen Ausführungsform umfasst ein Zyklus der Current Spinning-Technik genau zwei Phasen. Dabei ist in einer ersten Phase der erste Anschluss 51 des Hallelements 14 mit dem Bezugspotentialanschluss 36 und der dritte Anschluss 53 des Hallelements 14 mit dem Ausgang der Signalquelle 12 über den ersten beziehungsweise den zweiten Multiplexer 55, 56 gekoppelt. In der zweiten Phase ist der erste Anschluss 51 mit dem Ausgang der Signalquelle 12 und der dritte Anschluss 53 mit dem Bezugspotentialanschluss 36 gekoppelt. Der zweite und der vierte Anschluss 52, 54 des Hallelements 14 sind über den dritten und den vierten Multiplexer 57, 58 in der ersten und der zweiten Phase abwechselnd mit dem ersten beziehungsweise dem zweiten Eingang 59, 60 des Verstärkers 36 gekoppelt. In den zwei Phasen des Zyklusses wird somit die Richtung des durch das Hallelement 14 fließenden Stroms um 180 Winkelgrad gedreht.

In einer alternativen, nicht gezeigten Ausführungsform umfasst das Hallelement 14 weitere Anschlüsse, die mittels der vier Multiplexer 55 bis 58 mit der Signalquelle 12 und dem Verstärker 18 gekoppelt sind. Ein Zyklus zum Betreiben eines derartigen Hallelements 14 kann dabei mehr als vier Phasen aufweisen.

Figur 4B zeigt eine weitere beispielhafte Ausführungsform eines Details des Hallsensors 11. Der Hallsensor 11 umfasst das Hallelement 14 und ein weiteres Hallelement 61. Das Hallelement 14 und das weitere Hallelement 61 sind gemäß dem Prinzip des geometrischen Spinning verbunden. Das Hallelement 14 und das weitere Hallelement 61 sind als Hallelementpaar fest verbunden und können anstelle des Hallelements 14 in eine der oben geschilderten Hallsensoranordnungen eingesetzt werden. Das Hallelement 14 und das weitere Hallelement 61 sind beide mit dem Ausgang der Signalquelle 12 und dem Verstärker 18 gekoppelt. Die Richtung des Stromflusses durch das Hallelement 14 weist einen Winkel zur Richtung des Stromflusses durch das weitere Hallelement 61 auf. Bevorzugt beträgt der Winkel 45° oder 90°. Die Ausgänge des Hallelements 14 und des weiteren Hallelements 61 sind parallel geschaltet. Verbindungen zwischen Anschlüssen des Hallelements 14 zu Anschlüssen des weiteren Hallelements 61 sind fest und werden nicht umgeschaltet. Das Hallelementpaar, umfassend das Hallelement 14 und das weitere Hallelement 61, weist vier Anschlüsse 62 bis 65 auf. Ein erster Anschluss 62 ist mit dem Ausgang der Signalquelle 12, ein zweiter Anschluss 63 mit dem Bezugspotentialanschluss 36, ein dritter Anschluss 64 mit dem ersten Eingang 59 des Verstärkers 18 und ein vierter Anschluss 65 mit dem zweiten Eingang 60 des Verstärkers 18 verbunden. Das Hallelement 14 und das weitere Hallelement 61 weisen eine Parallelschaltung hinsichtlich der Eingangssignale I und der Sensorsignale VS auf. Der erste und der dritte Anschluss 51, 53 des Hallelements 14 sind an einen ersten beziehungsweise einen dritten Anschluss 51', 53' des weiteren Hallelements 61 permanent angeschlossen. Ebenso sind der zweite und der vierte Anschluss 52, 54 des Hallelements 14 an einen zweiten beziehungsweise einen vierten Anschluss 52', 54' des weiteren Hallelements 61 permanent angeschlossen. Folglich sind die Eingangssignalanschlüsse 51, 53, 51', 53' der beiden Hallelemente 14, 61 parallel geschaltet. Weiter sind die Ausgangssignalanschlüsse 52, 54, 52', 54' der beiden Hallelemente 14, 61 parallel geschaltet. Das Eingangssignal I kann als Strom oder Spannung ausgebildet sein.

In einer alternativen, nicht gezeigten Ausführungsform koppelt die Eingangsschaltung 15 beziehungsweise die Ausgangsschaltung 16 das Hallelementpaar mit der Signalquelle 12 beziehungsweise dem Verstärker 18. Dabei werden die vier Anschlüsse 62 bis 65 des Hallelementpaars über den ersten, zweiten, dritten und vierten Multiplexer 57 bis 58 mit dem Ausgang der Signalquelle 12, dem Bezugspotentialanschluss 36 sowie dem ersten und dem zweiten Eingang 59, 60 des Verstärkers 18 entsprechend den zwei oder vier Phasen der Current Spinning-Technik verbunden.

Optional kann mindestens ein zusätzliches Hallelement mit dem Hallelement 14 und dem weiteren Hallelement 61 gemäß dem Prinzip des geometrischen Spinning verbunden sein.

In einer alternativen, nicht gezeigten Ausführungsform weist der Hallsensor 11 vier Hallelemente 14, 61 auf, die miteinander verbunden sind. Dabei können Stromrichtungen durch die vier Hallelemente die Winkel 0°, 45°, 90° und 135° oder alternativ 0°, 90°, 180° und 270° gegenüber einer Gerade in einer ersten Hauptfläche eines Halbleiterkörpers, auf dem der Hallsensor 11 angeordnet ist, aufweisen.

Bezugszeichenliste

| 10 | Hallsensoranordnung |
|---|---|
| 11 | Hallsensor |
| 12 | Signalquelle |
| 13 | Ermittlungseinheit |
| 14 | Hallelement |
| 15 | Eingangsschaltung |
| 16 | Ausgangsschaltung |
| 17 | Auswerteschaltung |
| 18 | Verstärker |
| 19 | Steuerschaltung |
| 20 | Speicher |
| 21 | Berechnungseinheit |
| 22 | weiterer Speicher |
| 23 | Subtrahierer |
| 24 | Vergleicher |
| 25 | Triggereingang |
| 30 | Spule |
| 31 | Stromgenerator |
| 32 | Stromquelle |
| 33 | Digital-Analog-Wandler |
| 34 | Analog-Digital-Wandler |
| 35 | Referenzquelle |
| 36 | Bezugspotentialanschluss |

| 37 | Kompensationseinheit |
| 38 | Kompensationsstromquelle |
| 40 | Statussignalausgang |
| 41 | Nullpunktdetektor |
| 42 | Spannungsquelle |
| 43 | Knoten |
| 44 | Versorgungsspannungsanschluss |
| 50 | weitere Stromquelle |
| 51, 52, 53, 54 | Anschluss |
| 51', 52', 53', 54' | Anschluss |
| 55 | erster Multiplexer |
| 56 | zweiter Multiplexer |
| 57 | dritter Multiplexer |
| 58 | vierter Multiplexer |
| 59 | erster Eingang |
| 60 | zweiter Eingang |
| AV | verstärktes Sensorsignal |
| B | Magnetfeld |
| CS | Spulenfaktor |
| I | Eingangssignal |
| IC | Spulenstrom |
| IK | Kompensationsstrom |
| IP1 | erster Stromwert |
| IP2 | zweiter Stromwert |
| k | Offsetfaktor |
| n | Exponent |
| SB | Magnetfeldsignal |
| SI | Steuersignal |
| SIC | weiteres Steuersignal |
| STR | Triggersignal |
| STS | Statussignal |
| S1, S2, S3, S4 | Multiplexersteuersignale |
| V | Ausgangssignal |
| VD | Versorgungsspannung |
| VDD | weitere Versorgungsspannung |
| VOFF | Rest-Offsetspannung |
| VOFFC | gemessene Offsetspannung |
| VOFFR | restliche Offsetspannung |
| VREF | Referenzsignal |
| VS | Sensorsignal |
| $\alpha 2, \alpha 3$ | Skalierungsfaktor |

**Patentansprüche**

1. Verfahren zum Betreiben einer Hallsensoranordnung, umfassend:

   - Einstellen mindestens zweier betragsmäßig unterschiedlicher Werte (I1, I2) eines Eingangssignals (I) eines Hallsensors (11) der Hallsensoranordnung (10) und Bestimmen der dazugehörenden Werte (V1, V2) eines Ausgangssignals (V) des Hallsensors (11), wobei das Ausgangssignal (V) erst nach vollständigem Durchlaufen der Phasen eines Zyklus der Current Spinning-Technik bereitgestellt wird und der Wert des Eingangssignals (I) während der Phasen des Zyklus der Current Spinning-Technik konstant ist, sowie
   - Ermitteln eines Rest-Offsetwerts (k, VOFF) des Ausgangssignals (V) in Abhängigkeit von den Werten (V1, V2) des Ausgangssignals (V), die bei den mindestens zwei Werten (I1, I2) des Eingangssignals (I) bestimmt wurden.

2. Verfahren nach Anspruch 1,
   bei dem das Eingangssignal (I) als Strom oder Spannung realisiert ist.

3. Verfahren nach Anspruch 1 oder 2,
bei dem die mindestens zwei Werte (I1, I2) des Eingangssignals (I) oder ein Skalierungsfaktor ($\alpha$2, $\alpha$3) zwischen zwei Werten aus der Menge der mindestens zwei Werte (I1, I2) des Eingangssignals (I) bei der Ermittlung des Rest-Offsetwerts (k, VOFF) berücksichtigt werden.

4. Verfahren nach einem der Ansprüche 1 bis 3,
bei dem die Hallsensoranordnung (10) im Betrieb kalibriert wird, wobei eine Kalibrierphase, in welcher der Rest-Offsetwert (k, VOFF) ermittelt wird, zwischen zwei Betriebsphasen, in denen der Wert eines Magnetfelds (B) in Abhängigkeit von dem Rest-Offsetwert (k, VOFF) ermittelt wird, geschaltet ist.

5. Verfahren nach einem der Ansprüche 1 bis 4,
bei dem die Hallsensoranordnung (10) bei vorhandenem externen Magnetfeld (B), welches eine unbekannte Magnetfeldstärke aufweist, kalibriert wird.

6. Verfahren nach einem der Ansprüche 1 bis 5,
bei dem der Rest-Offsetwert ein Offsetfaktor (k) oder eine Rest-Offsetspannung (VOFF) ist und der Offsetfaktor (k) und die Rest-Offsetspannung (VOFF) gemäß der folgenden Gleichung berechnet werden:

$$\mathrm{VOFF} = \mathrm{k} \cdot \mathrm{I}^{\mathrm{n}},$$

wobei VOFF der Wert der Rest-Offsetspannung, k der Wert des Offsetfaktors, I der Wert des Eingangssignals und n der Wert eines Exponenten ist.

7. Verfahren nach Anspruch 6,
bei dem der Wert des Exponenten (n) vorgegeben ist.

8. Verfahren nach Anspruch 6,
bei dem der Wert des Exponenten (n) mittels Einstellen mindestens dreier betragsmäßig unterschiedlicher Werte (I1, I2, I3) des Eingangssignals (I) und Bestimmen der dazugehörenden Werte (V1, V2, V3) des Ausgangssignals (V) des Hallsensors (11) ermittelt wird.

9. Verfahren nach einem der Ansprüche 1 bis 8,
bei dem der Wert eines Magnetfelds (B) gemäß folgender Gleichung ermittelt wird:

$$\mathrm{V} = \mathrm{B} \cdot \mathrm{S} \cdot \mathrm{I} + \mathrm{VOFF},$$

wobei V der Wert des Ausgangssignals, B der Wert des Magnetfelds, S der Wert einer Empfindlichkeit, I der Wert des Eingangssignals und VOFF der Wert einer Rest-Offsetspannung ist.

10. Verfahren nach Anspruch 9,
bei dem der Wert der Empfindlichkeit (S) vorgegeben ist oder bei dem eine Spule (30) derart zum Hallsensor (11) angeordnet ist, dass das Magnetfeld der Spule (30) das vom Hallsensor (11) detektierte Magnetfeld beeinflusst, und der Wert der Empfindlichkeit (S) bei den mindestens zwei Werten (I1, I2) des Eingangssignals (I) mittels der Spule (30) ermittelt wird.

11. Verfahren nach einem der Ansprüche 1 bis 10,
bei dem eine Spule (30) derart zum Hallsensor (11) angeordnet ist, dass das Magnetfeld der Spule (30) das vom Hallsensor (11) detektierte Magnetfeld (B) beeinflusst, und in einer Betriebsphase der Wert eines Spulenstromes (IC) in Abhängigkeit von dem Rest-Offsetwert (k, VOFF) eingestellt ist.

12. Verfahren nach einem der Ansprüche 1 bis 10,
bei dem eine Spule (30) derart zum Hallsensor (11) angeordnet ist, dass das Magnetfeld der Spule (30) das vom Hallsensor (11) detektierte Magnetfeld (B) beeinflusst, und in einer Betriebsphase der Wert eines Spulenstromes (IC) derart eingestellt wird, dass das Ausgangssignal (V) näherungsweise den Wert 0 annimmt.

13. Verfahren nach Anspruch 12,
bei dem die Spule (30) derart mit dem Hallsensor (11) gekoppelt ist, dass der Spulenstrom (IC) als Eingangssignal (I) durch den Hallsensor (11) fließt.

14. Hallsensoranordnung, umfassend:

    - einen Hallsensor (11), umfassend

        - ein Hallelement (14),
        - eine Eingangsschaltung (15), die einen Eingang des Hallsensors (11) mit dem Hallelement (14) verbindet,
        - eine Ausgangsschaltung (16) und eine Auswerteschaltung (17), die das Hallelement (14) mit einem Ausgang des Hallsensors (11) verbinden, wobei ein von der Auswerteschaltung (17) bereitgestelltes Ausgangssignal (V) erst nach vollständigem Durchlaufen der Phasen eines Zyklus der Current Spinning-Technik bereitgestellt wird,

        - eine Signalquelle (12), die mit dem Eingang des Hallsensors (11) gekoppelt ist, und
        - eine Ermittlungseinheit (13), die mit dem Ausgang des Hallsensors (11) gekoppelt ist,
        **dadurch gekennzeichnet, dass**
        die Signalquelle (12) eingerichtet ist, mindestens zwei betragsmäßig unterschiedliche Werte (I1, 12) eines Eingangssignals (I) des Hallsensors (11) bereitzustellen, wobei der Wert des Eingangssignals (I) während der Phasen des Zyklus der Current Spinning-Technik konstant ist, und
        - die Ermittlungseinheit (13) eingerichtet ist, einen Rest-Offsetwert (k, VOFF) eines Ausgangssignals (V) des Hallsensors (11) in Abhängigkeit von den Werten (V1, V2) des Ausgangssignals (V), die bei den mindestens zwei Werten (I1, 12) des Eingangssignals (I) bestimmt werden, zu ermitteln.

15. Hallsensoranordnung nach Anspruch 14,
umfassend eine Spule (30), die fest mit dem Hallsensor (11) verbunden und derart zum Hallsensor (11) angeordnet ist, dass das vom Hallsensor (11) detektierbare Magnetfeld (B) vom Magnetfeld der Spule (30) beeinflussbar ist.

**Claims**

1. A method of operating a Hall sensor assembly, comprising:

    - setting at least two values (I1, 12), having different absolute magnitudes, of an input signal (I) of a Hall sensor (11) of the Hall sensor assembly (10) and determining the associated values (V1, V2) of an output signal (V) of the Hall sensor (11), the output signal (V) being made available not until having completely run through the phases of a cycle of the Current Spinning Technology and the value of the input signal (I) being constant during the phases of the cycle of the Current Spinning Technology, and
    - determining a residual offset value (k, VOFF) of the output signal (V) as a function of the values (V1, V2) of the output signal (V), which have been determined with the at least two values (I1, 12) of the input signal (I).

2. The method according to claim 1,
in which the input signal (I) is realized as a current or a voltage.

3. The method according to claim 1 or 2,
in which the at least two values (I1, 12) of the input signal (I) or a scaling factor ($\alpha 2$, $\alpha 3$) between two values of the set of the at least two values (I1, 12) of the input signal (I) are taken into consideration in the determination of the residual offset value (k, VOFF).

4. The method according to any of the claims 1 to 3,
in which the Hall sensor assembly (10) is calibrated in use, a calibration phase in which the residual offset value (k, VOFF) is determined being interposed between two operation phases in which the value of a magnetic field (B) is determined as a function of the residual offset value (k, VOFF).

5. The method according to any of the claims 1 to 4,

in which the Hall sensor assembly (10) is calibrated in the presence of an external magnetic field (B) having an unknown magnetic field strength.

6. The method according to any of the claims 1 to 5,
in which the residual offset value is an offset factor (k) or a residual offset voltage (VOFF), the offset factor (k) and the residual offset voltage (VOFF) being calculated according to the following equation:

$$VOFF = k \cdot I^n,$$

wherein VOFF is the value of the residual offset voltage, k is the value of the offset factor, I is the value of the input signal and n is the value of an exponent.

7. The method according to claim 6,
in which the value of the exponent (n) is predefined.

8. The method according to claim 6,
in which the value of the exponent (n) is determined by means of setting at least three values (I1, I2), having different absolute magnitudes, of the input signal (I) and determining the associated values (V1, V2, V3) of the output signal (V) of the Hall sensor (11).

9. The method according to any of the claims 1 to 8,
in which the value of a magnetic field (B) is determined according to the following equation:

$$V = B \cdot S \cdot I + VOFF,$$

wherein V is the value of the output signal, B is the value of the magnetic field, S is the value of a sensitivity, I is the value of the input signal and VOFF is the value of a residual offset voltage.

10. The method according to claim 9,
in which the value of the sensitivity (S) is predefined or in which a coil (30) is arranged with respect to the Hall sensor (11) in such a way that the magnetic field of the coil (30) has an influence on the magnetic field detected by the Hall sensor (11), and the value of the sensitivity (S) is determined with the at least two values (I1, I2) of the input signal (I) by means of the coil (30).

11. The method according to any of the claims 1 to 10,
in which a coil (30) is arranged with respect to the Hall sensor (11) in such a way that the magnetic field of the coil (30) has an influence on the magnetic field (B) detected by the Hall sensor (11), and the value of a coil current (IC) is set in an operation phase as a function of the residual offset value (k, VOFF).

12. The method according to any of the claims 1 to 10,
in which a coil (30) is arranged with respect to the Hall sensor (11) in such a way that the magnetic field of the coil (30) has an influence on the magnetic field (B) detected by the Hall sensor (11), and the value of a coil current (IC) is set in an operation phase in such a way that the output signal (V) approaches zero value.

13. The method according to claim 12,
in which the coil (30) is coupled to the Hall sensor (11) in such a way that the coil current (IC) flows through the Hall sensor (11) as an input signal (I).

14. A Hall sensor assembly, comprising:

- a Hall sensor (11), comprising

- a Hall element (14),
- an input circuit (15) connecting an input of the Hall sensor (11) to the Hall element (14),
- an output circuit (16) and an evaluation circuit (17) which connect the Hall element (14) to an output of the Hall sensor (11), an output signal (V) provided by the evaluation circuit (17) being made available not until having completely run through the phases of a cycle of the Current Spinning Technology,

- a signal source (12) which is coupled to the input of the Hall sensor (11), and
- a determination unit (13) which is coupled to the output of the Hall sensor (11),
**characterized in that**
- the signal source (12) is arranged for providing at least two values (I1, I2), having different absolute magnitudes, of an input signal (I) of the Hall sensor (11), with the value of the input signal (I) being constant during the phases of the cycle of the Current Spinning Technology, and
- the determination unit (13) is arranged for determining a residual offset value (k, VOFF) of an output signal (V) of the Hall sensor (11) as a function of the values (V1, V2) of the output signal (V), which are determined with the at least two values (I1, I2) of the input signal (I).

15. The Hall sensor assembly according to claim 14, comprising a coil (30) which is firmly connected to the Hall sensor (11) and arranged with respect to the Hall sensor (11) in such a manner that the magnetic field (B) which can be detected by the Hall sensor (11) can be influenced by the magnetic field of the coil (30).

**Revendications**

1. Procédé destiné à exploiter un ensemble capteur à effet Hall, comprenant:

    - réglage d'au moins deux valeurs (I1, I2) numériquement différentes d'un signal d'entrée (I) d'un capteur à effet Hall (11) de l'ensemble capteur à effet Hall (10) et détermination des valeurs associées (V1, V2) d'un signal de sortie (V) du capteur à effet Hall (11), sachant que le signal de sortie (V) n'est mis à disposition qu'après déroulement complet des phases d'un cycle de la technique de Current Spinning et la valeur du signal d'entrée (I) est constante pendant les phases du cycle de la technique de Current Spinning, ainsi que
    - détermination d'une valeur de décalage résiduelle (k, VOFF) du signal de sortie (V) en fonction des valeurs (V1, V2) du signal de sortie (V) qui ont été déterminées pour les au moins deux valeurs (I1, I2) du signal d'entrée (I).

2. Procédé selon la revendication 1,
dans lequel le signal d'entrée (I) est réalisé comme courant ou tension.

3. Procédé selon la revendication 1 ou 2,
dans lequel les au moins deux valeurs (I1, I2) du signal d'entrée (I) ou un facteur de mise à l'échelle ($\alpha 2$, $\alpha 3$) entre deux valeurs issues de l'ensemble des au moins deux valeurs (I1, I2) du signal d'entrée (I) sont pris en compte lors de la détermination de la valeur de décalage résiduelle (k, VOFF).

4. Procédé selon l'une des revendications 1 à 3,
dans lequel l'ensemble capteur à effet Hall (10) est calibré en exploitation, sachant qu'une phase de calibrage dans laquelle la valeur de décalage résiduelle (k, VOFF) est déterminée, est intercalée entre deux phases d'exploitation dans lesquelles la valeur d'un champ magnétique (B) est déterminée en fonction de la valeur de décalage résiduelle (k, VOFF).

5. Procédé selon l'une des revendications 1 à 4,
dans lequel l'ensemble capteur à effet Hall (10) est calibré en présence d'un champ magnétique (B) externe qui présente une intensité de champ magnétique inconnue.

6. Procédé selon l'une des revendications 1 à 5,
dans lequel la valeur de décalage résiduelle est un facteur de décalage (k) ou une tension de décalage résiduelle (VOFF) et le facteur de décalage (k) et la tension de décalage résiduelle (VOFF) sont calculés d'après l'équation suivante:

$$VOFF = k \cdot I^n,$$

VOFF étant la valeur de la tension de décalage résiduelle, k la valeur du facteur de décalage, I la valeur du signal d'entrée et n la valeur d'un exposant.

7.  Procédé selon la revendication 6,
    dans lequel la valeur de l'exposant (n) est spécifiée.

8.  Procédé selon la revendication 6,
    dans lequel la valeur de l'exposant (n) est déterminée moyennant réglage d'au moins trois valeurs (I1, 12, 13) numériquement différentes du signal d'entrée (I) et détermination des valeurs associées (V1, V2, V3) du signal de sortie (V) du capteur à effet Hall (11).

9.  Procédé selon l'une des revendications 1 à 8,
    dans lequel la valeur d'un champ magnétique (B) est déterminée d'après l'équation suivante:

$$V = B \cdot S \cdot I + VOFF,$$

V étant la valeur du signal de sortie, B la valeur du champ magnétique, S la valeur d'une sensibilité, I la valeur du signal d'entrée et VOFF la valeur d'une tension de décalage résiduelle.

10. Procédé selon la revendication 9,
    dans lequel la valeur de la sensibilité (S) est spécifiée ou dans lequel une bobine (30) est disposée de telle façon par rapport au capteur à effet Hall (11) que le champ magnétique de la bobine (30) influence le champ magnétique détecté par le capteur à effet Hall (11), et la valeur de la sensibilité (S) est déterminée au moyen de la bobine (30) pour les au moins deux valeurs (I1, 12) du signal d'entrée (I).

11. Procédé selon l'une des revendications 1 à 10,
    dans lequel une bobine (30) est disposée de telle façon par rapport au capteur à effet Hall (11) que le champ magnétique de la bobine (30) influence le champ magnétique (B) détecté par le capteur à effet Hall (11), et, dans une phase d'exploitation, la valeur d'un courant de bobine (IC) est réglée en fonction de la valeur de décalage résiduelle (k, VOFF).

12. Procédé selon l'une des revendications 1 à 10,
    dans lequel une bobine (30) est disposée de telle façon par rapport au capteur à effet Hall (11) que le champ magnétique de la bobine (30) influence le champ magnétique (B) détecté par le capteur à effet Hall (11), et, dans une phase d'exploitation, la valeur d'un courant de bobine (IC) est réglée de telle façon que le signal de sortie (V) prenne approximativement la valeur 0.

13. Procédé selon la revendication 12,
    dans lequel la bobine (30) est couplée de telle façon au capteur à effet Hall (11) que le courant de bobine (IC) passe comme signal d'entrée (I) à travers le capteur à effet Hall (11).

14. Ensemble capteur à effet Hall, comprenant:

    - un capteur à effet Hall, comprenant

        - un élément à effet Hall (14),
        - un circuit d'entrée (15) qui relie une entrée du capteur à effet Hall (11) à l'élément à effet Hall (14),
        - un circuit de sortie (16) et un circuit d'évaluation (17) qui relient l'élément à effet Hall (14) à une sortie du capteur à effet Hall (11), sachant qu'un signal de sortie (V) mis à disposition par le circuit d'évaluation (17) n'est mis à disposition qu'après déroulement complet des phases d'un cycle de la technique de Current Spinning,

- une source de signal (12) qui est couplée à l'entrée du capteur à effet Hall (11), et
- une unité de détermination (13) qui est couplée à la sortie du capteur à effet Hall (11),

**caractérisé en ce que**

la source de signal (12) est configurée pour mettre à disposition au moins deux valeurs (I1, I2) numériquement différentes d'un signal d'entrée (I) du capteur à effet Hall (11), sachant que la valeur du signal d'entrée (I) est constante pendant les phases du cycle de la technique de Current Spinning, et

- l'unité de détermination (13) est configurée pour déterminer une valeur de décalage résiduelle (k, VOFF) d'un signal de sortie (V) du capteur à effet Hall (11) en fonction des valeurs (V1, V2) du signal de sortie (V) qui sont déterminées pour les au moins deux valeurs (I1, I2) du signal d'entrée (I).

15. Ensemble capteur à effet Hall selon la revendication 14, comprenant une bobine (30) qui est fermement reliée au capteur à effet Hall (11) et disposée de telle façon par rapport au capteur à effet Hall (11) que le champ magnétique (B) détectable par le capteur à effet Hall (11) soit influençable par le champ magnétique de la bobine (30).

## FIG 1A

## FIG 1B

## FIG 1C

$$y = 9561.9x^{3.2238}$$

VOFF [µV] vs I [mA]

## FIG 1D

VOFF

VOFFC

VOFFR

[µV] vs Nr.

FIG 2A

FIG 2B

FIG 2C

FIG 2D

FIG 3A

FIG 3B

FIG 3C

FIG 3D

FIG 3E

## FIG 4A

## FIG 4B

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6064202 A
- WO 0054068 A1
- DE 102004021863 A1

**In der Beschreibung aufgeführte Nicht-Patentliteratur**

- **P. RUTHER et al.** Influence of the Junction Field Effect on the Offset Voltage of Integrated Hall Plates. *Sixteenth European Conference on Solid-State Transducers, 15. - 18. September 2002, Prag, Tschechische Republik,* 18. September 2002, 1209-1212

- **P. RUTHER et al.** Influence of the Junction Field Effect on the Office Voltage of Integrated Hall Plate. *Sixteenth European Conference on Solid-State Transducers, 15. - 18. September 2002, Prag, Tschechische Republik,* 15. September 2002, 1209-1212